# EUROPEAN PATENT SPECIFICATION

(11) **EP 4 339 945 B1**
(45) Date of publication and mention of the grant of the patent: **22.04.2026**
(21) Application number: 22819633.3
(22) Date of filing: 10.06.2022
(51) Int. Cl.: G10L 19/02, G06N 3/04, G06N 3/08, H03M 7/30, H04N 19/117, G10L 19/04, G06N 3/045

(54) **ENCODING METHOD AND DEVICE, DECODING METHOD AND DEVICE, AND STORAGE MEDIUM**
CODIERUNGSVERFAHREN UND -VORRICHTUNG, DECODIERUNGSVERFAHREN UND -VORRICHTUNG SOWIE SPEICHERMEDIUM
PROCÉDÉ ET DISPOSITIF D'ENCODAGE, PROCÉDÉ ET DISPOSITIF DE DÉCODAGE ET SUPPORT DE STOCKAGE

(30) Priority: 11.06.2021 CN 202110654037
(43) Date of publication of application: 20.03.2024
(73) Proprietor: Huawei Technologies Co., Ltd., Longgang Shenzhen, Guangdong 518129 (CN)
(72) Inventor: LI, Jiawei, Shenzhen, Guangdong 518129 (CN); XIA, Bingyin, Shenzhen, Guangdong 518129 (CN); WANG, Zhe, Shenzhen, Guangdong 518129 (CN)
(74) Representative: Thun, Clemens
(86) International application number: PCT/CN2022/098016
(87) International publication number: WO 2022/258036

(56) References cited:
- WO-A1-02/069326
- CN-A- 103 065 637
- CN-A- 104 769 671
- CN-A- 111 386 568
- CN-A- 111 899 748
- CN-A- 112 639 967
- US-A1- 2020 135 220
- FEJGIN ROY ET AL: "Source Coding of Audio Signals with a Generative Model", ICASSP 2020 - 2020 IEEE INTERNATIONAL CONFERENCE ON ACOUSTICS, SPEECH AND SIGNAL PROCESSING (ICASSP), IEEE, 4 May 2020 (2020-05-04), pages 341 - 345, XP033792896, DOI: 10.1109/ICASSP40776.2020.9053220
- JING WANG ET AL: "Context-based adaptive arithmetic coding in time and frequency domain for the lossless compression of audio coding parameters at variable rate", EURASIP JOURNAL ON AUDIO, SPEECH, AND MUSIC PROCESSING, 21 May 2013 (2013-05-21), pages 1, XP055104567, Retrieved from the Internet <URL:http://asmp.eurasipjournals.com/content/pdf/1687-4722-2013-9.pdf> [retrieved on 20140226], DOI: 10.1186/1687-4722-2013-9

## Description

### TECHNICAL FIELD

Embodiments of this application relate to the field of encoding and decoding technologies, and in particular, to an encoding method and apparatus, a decoding method and apparatus, a device, a storage medium, and a computer program.

### BACKGROUND

Encoding and decoding technologies are indispensable in media applications such as media communication and media broadcasting. Therefore, how to perform encoding and decoding becomes one of focuses in the industry.

The conventional technology provides an audio encoding and decoding method. In the method, during audio encoding, time-frequency transformation is performed on a time-domain signal of audio to obtain a frequency-domain signal of the audio. The frequency-domain signal is whitened to obtain a whitened spectrum. The whitened spectrum is processed by an encoding neural network model to obtain a latent variable The latent variable indicates a feature (to be specific, a spectral feature) of the whitened spectrum. Entropy encoding is performed on the latent variable, and an entropy encoding result is written into a bitstream. During audio decoding, a reconstructed latent variable is determined based on the bitstream. The reconstructed latent variable is processed by a decoding neural network model to obtain a reconstructed whitened spectrum. The reconstructed whitened spectrum is de-whitened to obtain a reconstructed frequency-domain signal. Inverse transformation of time-frequency transformation is performed on the reconstructed frequency-domain signal to obtain a reconstructed time-domain signal.

However, a statistical average energy distribution range of the whitened spectrum obtained in the conventional technology is large. To be specific, statistical average energy of spectral lines for different frequencies in the whitened spectrum differs greatly. In addition, a spectral line in a spectral region with low statistical average energy is likely to be lost during processing by the encoding neural network model. To be specific, some spectral features are likely to be lost during encoding in the conventional technology. Consequently, encoding quality is low.

US 2020/0135220 Al discloses an audio signal encoding method and audio signal decoding method, and an encoder and decoder performing the same. The audio signal encoding method includes applying an audio signal to a training model including N autoencoders provided in a cascade structure, encoding an output result derived through the training model, and generating a bitstream with respect to the audio signal based on the encoded output result.

"Source Coding of Audio Signals with a Generative Model" (FEGGIN ROY ET AL, ICCASSP 2020, SPEECH AND SIGNAL PROCESSING, IEEE, 4 MAY 2020) discloses source coding of audio signals with the help of a generative model.

"Context-based adaptive arithmetic coding in time and frequency domain for the lossless compression of audio coding parameters at variable rate"(Jing Wang ET AL, EURASIO Journal on Audio, Speech, and Music Processing, 21 May 2013) discloses a novel lossless compression technique of the context-based adaptive arithmetic coding which can be used to further compress the quantized parameters in audio codec.

### SUMMARY

The invention is defined in the independent claims. Additional features of the invention are provided in the dependent claims. In the following, parts of the description and drawings referring to embodiments which are not covered by the claims are not presented as embodiments of the invention, but as examples useful for understanding the invention.

An encoding method and apparatus, a decoding method and apparatus, a device, a storage medium, and a computer program are disclosed, to improve encoding quality. The technical solutions are as follows:

According to a first aspect, an encoding method is provided. The encoding method includes: determining a first whitened spectrum for to-be-encoded media data; shaping the first whitened spectrum to obtain a second whitened spectrum, where a spectral amplitude of the second whitened spectrum in a target frequency band is greater than or equal to a spectral amplitude of the first whitened spectrum in the target frequency band; processing the second whitened spectrum by using an encoding neural network model to obtain a first latent variable, where the first latent variable indicates a feature of the second whitened spectrum; and encoding the first latent variable into a bitstream.

To be specific, in this solution, a whitened spectrum is shaped to increase a spectral amplitude in the target frequency band. This can reduce a dynamic range of statistical average energy distribution of the whitened spectrum. To be specific, a difference between statistical average energy of spectral lines for different frequencies in the obtained second whitened spectrum is small. In this way, when the second whitened spectrum is processed by using the encoding neural network model, more spectral features can be retained, in other words, more spectral lines are encoded, so that encoding quality is improved.

A frequency band, in the first whitened spectrum, that needs to be shaped is a target frequency band corresponding to the media data. Optionally, the target frequency band is determined based on one or more factors of a sampling rate, a channel quantity, an encoding rate, encoding bandwidth, and an encoding mode that correspond to the media data. To be specific, in this embodiment of this application, there are one or more reference factors for determining the target frequency band.

Optionally, the target frequency band covers an entire range or a partial range of the spectral range of the media data. To be specific, an entire frequency band of the first whitened spectrum may be shaped, or a part of a frequency band of the first whitened spectrum may be shaped.

Optionally, the target frequency band is preset, or the target frequency band is determined based on the first whitened spectrum. To be specific, the target frequency band is preset or dynamically determined.

If the target frequency band is preset, the target frequency band may be preset based on the foregoing one or more factors. Alternatively, some frequency bands with low spectral energy are determined through statistical analysis on spectral energy distribution of a large quantity of media data samples, and the frequency bands with low spectral energy are set as the target frequency band.

If the target frequency band is determined based on the first whitened spectrum, before the shaping the first whitened spectrum to obtain a second whitened spectrum, the method further includes: dividing a spectral range of the media data into a first quantity of first frequency subbands; determining an average value of spectral energy of the first whitened spectrum in each of the first quantity of first frequency subbands to obtain a first quantity of average values of spectral energy of frequency subbands; determining an average value of spectral energy of the first whitened spectrum within the spectral range; and determining, based on the average value of spectral energy and the first quantity of average values of spectral energy of frequency subbands, a first frequency subband included in the target frequency band.

Optionally, the determining, based on the average value of spectral energy and the first quantity of average values of spectral energy of frequency subbands, a first frequency subband included in the target frequency band includes: using a first frequency subband corresponding to an average value of spectral energy, in the first quantity of average values of spectral energy of frequency subbands, whose difference from the average value of spectral energy exceeds a specified threshold as the first frequency subband included in the target frequency band. To be specific, a first frequency subband with low spectral energy is selected based on an energy distribution status of the first whitened spectrum for the to-be-encoded media data, and the selected first frequency subband is included in the target frequency band.

Optionally, the shaping the first whitened spectrum to obtain a second whitened spectrum includes: shaping the first whitened spectrum based on a gain adjustment factor to obtain the second whitened spectrum.

Optionally, the target frequency band includes a second quantity of second frequency subbands, the gain adjustment factor includes an adjustment factor corresponding to each of the second quantity of second frequency subbands, and the shaping the first whitened spectrum based on a gain adjustment factor to obtain the second whitened spectrum includes: determining a spectral value of the first whitened spectrum at a frequency in each of the second quantity of second frequency subbands; and adjusting the spectral value of the first whitened spectrum at the frequency in each of the second quantity of second frequency subbands based on an adjustment factor corresponding to each of the second quantity of second frequency subbands, to obtain the second whitened spectrum. Optionally, the second quantity of second frequency subbands are determined based on the first frequency subband included in the target frequency band.

For example, a first to-be-adjusted frequency subband is any one of the second quantity of second frequency subbands. For the first to-be-adjusted frequency subband, a spectral value of the first whitened spectrum at a frequency in the first to-be-adjusted frequency subband is multiplied or divided by a corresponding adjustment factor to obtain a spectral value of the second whitened spectrum at a frequency in the first to-be-adjusted frequency subband. It should be noted that, the first whitened spectrum is preset to be adjusted through multiplication by the adjustment factor, or the first whitened spectrum is preset to be adjusted through division by the adjustment factor, that is, multiplication or division is directly performed based on the setting during encoding.

Optionally, adjustment factors corresponding to all of the second quantity of second frequency subbands is determined in a same manner or different manners, and an adjustment factor corresponding to a first to-be-adjusted frequency subband of the second quantity of second frequency subbands meets the following condition:
frequencies in the first to-be-adjusted frequency subband correspond to one adjustment factor, and the adjustment factor is a preset value; or frequencies in the first to-be-adjusted frequency subband correspond to different adjustment factors, and adjustment factors corresponding to at least a part of the frequencies are determined through linear interpolation; or adjustment factors corresponding to frequencies in the first to-be-adjusted frequency subband are different, and the adjustment factors corresponding to the frequencies are determined according to a preset function. To be specific, a first implementation of determining the adjustment factor corresponding to the first to-be-adjusted frequency subband is setting the corresponding adjustment factor to a preset value, a second implementation is determining the corresponding adjustment factor through linear interpolation, and a third implementation is determining the corresponding adjustment factor according to the preset function. The following describes the second implementation and the third implementation.

Second implementation: Adjustment factors corresponding to at least a part of the frequencies in the first to-be-adjusted frequency subband are determined through linear interpolation.

The adjustment factors corresponding to the at least a part of the frequencies are determined in the following manner: determining a start adjustment factor corresponding to the first to-be-adjusted frequency subband; determining a stop adjustment factor corresponding to the first to-be-adjusted frequency subband; and determining, based on the start adjustment factor and the stop adjustment factor through linear interpolation, the adjustment factors corresponding to the at least a part of the frequencies.

Optionally, the at least a part of the frequencies do not include a start frequency or a stop frequency of the first to-be-adjusted frequency subband, an adjustment factor corresponding to the start frequency is the start adjustment factor, and an adjustment factor corresponding to the stop frequency is the stop adjustment factor.

Optionally, both the start adjustment factor and the stop adjustment factor are preset values; or the start adjustment factor is a preset value, and the stop adjustment factor is a non-preset value; or the start adjustment factor is a non-preset value, and the stop adjustment factor is a preset value; or both the start adjustment factor and the stop adjustment factor are non-preset values.

Optionally, when the stop adjustment factor is a non-preset value, the stop adjustment factor is an adjustment factor corresponding to a start frequency of a second to-be-adjusted frequency subband, the second to-be-adjusted frequency subband is a second frequency subband located after the first to-be-adjusted frequency subband in the second quantity of second frequency subbands, and the first to-be-adjusted frequency subband and the second to-be-adjusted frequency subband are continuous. To be specific, because the second to-be-adjusted frequency subband is a frequency band that is located after the first to-be-adjusted frequency subband and that is continuous with the first to-be-adjusted frequency subband, the adjustment factor corresponding to the start frequency of the second to-be-adjusted frequency subband may be used as the stop adjustment factor corresponding to the first to-be-adjusted frequency subband. An adjustment factor corresponding to a stop frequency of the second to-be-adjusted frequency subband may be preset, determined through linear interpolation, or determined according to a preset function. This is not limited in this embodiment of this application.

Optionally, when the start adjustment factor is a non-preset value, the start adjustment factor is an adjustment factor corresponding to a stop frequency of a third to-be-adjusted frequency subband, the third to-be-adjusted frequency subband is a second frequency subband located before the first to-be-adjusted frequency subband in the second quantity of second frequency subbands, and the first to-be-adjusted frequency subband and the third to-be-adjusted frequency subband are continuous. To be specific, because the third to-be-adjusted frequency subband is a frequency band that is located before the first to-be-adjusted frequency subband and that is continuous with the first to-be-adjusted frequency subband, an adjustment factor corresponding to a start frequency of the third to-be-adjusted frequency subband may be used as the stop adjustment factor corresponding to the first to-be-adjusted frequency subband. The adjustment factor corresponding to the stop frequency of the third to-be-adjusted frequency subband may be preset, determined through linear interpolation, or determined according to a preset function. This is not limited in this embodiment of this application.

Third implementation: The adjustment factor corresponding to the first to-be-adjusted frequency subband is determined according to the preset function.

In this embodiment of this application, if the adjustment factors corresponding to the frequencies in the first to-be-adjusted frequency subband are determined according to the preset function, before the shaping the first whitened spectrum based on a gain adjustment factor to obtain the second whitened spectrum, the method further includes: obtaining, from one or more stored preset functions, a preset function corresponding to the first to-be-adjusted frequency subband, and obtaining a function argument range corresponding to the first to-be-adjusted frequency subband; and determining the adjustment factors corresponding to the frequencies in the first to-be-adjusted frequency subband according to the preset function corresponding to the first to-be-adjusted frequency subband and based on the function argument range corresponding to the first to-be-adjusted frequency subband.

Each of the one or more preset functions corresponds to one second frequency subband. The one or more preset functions are the same or different. Function argument ranges of the preset functions may also be the same or different. This is not limited in this embodiment of this application. Optionally, the preset function corresponding to the first to-be-adjusted frequency subband is a non-linear function. In this way, a spectral value of a frequency in the first to-be-adjusted frequency subband is subsequently adjusted based on a non-linear relationship. For example, the preset function is a quadratic function or a log function. If the preset function corresponding to the first to-be-adjusted frequency subband is a linear function, a spectral value of a frequency in the first to-be-adjusted frequency subband is subsequently adjusted based on a linear relationship. A principle thereof is essentially similar to a principle of linear interpolation.

Optionally, before the shaping the first whitened spectrum to obtain a second whitened spectrum, the method further includes: detecting whether the first whitened spectrum meets a shaping condition; and if the first whitened spectrum meets the shaping condition, performing the step of shaping the first whitened spectrum to obtain a second whitened spectrum. To be specific, in this embodiment of this application, a shaping detection mechanism can be further introduced to detect whether the first whitened spectrum needs to be shaped. When the first whitened spectrum meets the shaping condition, the first whitened spectrum is shaped. When the first whitened spectrum does not meet the shaping condition, the first whitened spectrum is not shaped, that is, the second whitened spectrum is the first whitened spectrum.

Optionally, the detecting whether the first whitened spectrum meets a shaping condition includes: determining first average energy and second average energy based on the first whitened spectrum, where the first average energy is an average value of spectral energy of the first whitened spectrum in a first preset frequency band, and the second average energy is an average value of spectral energy of the first whitened spectrum in a second preset frequency band; and if a difference between the first average energy and the second average energy exceeds a first threshold, determining that the first whitened spectrum meets the shaping condition.

It should be noted that the shaping detection mechanism is optional. For example, when the encoding rate is a specified encoding rate, the first whitened spectrum is directly shaped without shaping detection; or when the encoding rate is not a specified encoding rate, shaping detection is performed, and the first whitened spectrum is shaped when the first whitened spectrum meets the shaping condition. For example, the first whitened spectrum is directly shaped in the case of a low encoding rate, and shaping detection is performed in the case of a high encoding rate.

According to a second aspect, a decoding method is provided. Corresponding to the foregoing encoding method, the decoding method includes:
determining a reconstructed first latent variable based on a bitstream; processing the reconstructed first latent variable by using a decoding neural network model to obtain a reconstructed second whitened spectrum; adjusting the reconstructed second whitened spectrum to obtain a reconstructed first whitened spectrum, where a spectral amplitude of the reconstructed first whitened spectrum in a target frequency band is less than or equal to a spectral amplitude of the reconstructed second whitened spectrum in the target frequency band; and determining reconstructed media data based on the reconstructed first whitened spectrum.

Optionally, the adjusting the reconstructed second whitened spectrum to obtain a reconstructed first whitened spectrum includes: adjusting the reconstructed second whitened spectrum based on a gain adjustment factor to obtain the reconstructed first whitened spectrum.

Optionally, the target frequency band includes a second quantity of second frequency subbands, the gain adjustment factor includes an adjustment factor corresponding to each of the second quantity of second frequency subbands, and the adjusting the reconstructed second whitened spectrum based on a gain adjustment factor to obtain the reconstructed first whitened spectrum includes: determining a spectral value of the reconstructed second whitened spectrum at a frequency in each of the second quantity of second frequency subbands; and adjusting the spectral value of the reconstructed second whitened spectrum at the frequency in each of the second quantity of second frequency subbands based on an adjustment factor corresponding to each of the second quantity of second frequency subbands, to obtain the reconstructed first whitened spectrum.

Optionally, adjustment factors corresponding to all of the second quantity of second frequency subbands is determined in a same manner or different manners, and an adjustment factor corresponding to a first to-be-adjusted frequency subband of the second quantity of second frequency subbands meets the following condition:
frequencies in the first to-be-adjusted frequency subband correspond to one adjustment factor, and the adjustment factor is a preset value; or
frequencies in the first to-be-adjusted frequency subband correspond to different adjustment factors, and adjustment factors corresponding to at least a part of the frequencies are determined through linear interpolation; or
adjustment factors corresponding to frequencies in the first to-be-adjusted frequency subband are different, and the adjustment factors corresponding to the frequencies are determined according to a preset function.

Optionally, the adjustment factors corresponding to the at least a part of the frequencies are determined in the following manner:
determining a start adjustment factor corresponding to the first to-be-adjusted frequency subband; determining a stop adjustment factor corresponding to the first to-be-adjusted frequency subband; and determining, based on the start adjustment factor and the stop adjustment factor through linear interpolation, the adjustment factors corresponding to the at least a part of the frequencies.

Optionally, the at least a part of the frequencies do not include a start frequency or a stop frequency of the first to-be-adjusted frequency subband, an adjustment factor corresponding to the start frequency is the start adjustment factor, and an adjustment factor corresponding to the stop frequency is the stop adjustment factor.

Optionally, both the start adjustment factor and the stop adjustment factor are preset values; or the start adjustment factor is a preset value, and the stop adjustment factor is a non-preset value; or the start adjustment factor is a non-preset value, and the stop adjustment factor is a preset value; or both the start adjustment factor and the stop adjustment factor are non-preset values.

Optionally, when the stop adjustment factor is a non-preset value, the stop adjustment factor is an adjustment factor corresponding to a start frequency of a second to-be-adjusted frequency subband, the second to-be-adjusted frequency subband is a second frequency subband located after the first to-be-adjusted frequency subband in the second quantity of second frequency subbands, and the first to-be-adjusted frequency subband and the second to-be-adjusted frequency subband are continuous.

Optionally, when the start adjustment factor is a non-preset value, the start adjustment factor is an adjustment factor corresponding to a stop frequency of a third to-be-adjusted frequency subband, the third to-be-adjusted frequency subband is a second frequency subband located before the first to-be-adjusted frequency subband in the second quantity of second frequency subbands, and the first to-be-adjusted frequency subband and the third to-be-adjusted frequency subband are continuous.

Optionally, if the adjustment factors corresponding to the frequencies in the first to-be-adjusted frequency subband are determined according to the preset function, before the shaping the first whitened spectrum based on a gain adjustment factor to obtain the second whitened spectrum, the method further includes: obtaining, from one or more stored preset functions, a preset function corresponding to the first to-be-adjusted frequency subband, and obtaining a function argument range corresponding to the first to-be-adjusted frequency subband; and determining the adjustment factors corresponding to the frequencies in the first to-be-adjusted frequency subband according to the preset function corresponding to the first to-be-adjusted frequency subband and based on the function argument range corresponding to the first to-be-adjusted frequency subband.

Optionally, the target frequency band is determined based on one or more factors of a sampling rate, a channel quantity, an encoding rate, encoding bandwidth, and an encoding mode that correspond to the media data.

Optionally, the target frequency band covers an entire range or a partial range of the spectral range of the media data.

According to a third aspect, an encoding apparatus is provided. The encoding apparatus has a function of implementing the behavior in the encoding method in the first aspect. The encoding apparatus includes one or more modules. The one or more modules are configured to implement the encoding method provided in the first aspect.

According to a fourth aspect, a decoding apparatus is provided. The decoding apparatus has a function of implementing the behavior in the decoding method in the second aspect. The decoding apparatus includes one or more modules. The one or more modules are configured to implement the decoding method provided in the second aspect.

According to a fifth aspect, an encoder-side device is provided. The encoder-side device includes a processor and a memory. The memory is configured to store a program for performing the encoding method provided in the first aspect. The processor is configured to execute the program stored in the memory, to implement the encoding method provided in the first aspect.

Optionally, the encoder-side device may further include a communication bus. The communication bus is configured to establish a connection between the processor and the memory.

According to a sixth aspect, a decoder-side device is provided. The decoder-side device includes a processor and a memory. The memory is configured to store a program for performing the decoding method provided in the second aspect. The processor is configured to execute the program stored in the memory, to implement the decoding method provided in the second aspect.

Optionally, the decoder-side device may further include a communication bus. The communication bus is configured to establish a connection between the processor and the memory.

According to a seventh aspect, a computer-readable storage medium is provided. The storage medium stores instructions. When the instructions run on a computer, the computer is enabled to perform the steps of the encoding method according to the first aspect or the steps of the decoding method according to the second aspect.

According to an eighth aspect, a computer-readable storage medium is provided. The storage medium stores instructions. When the instructions run on a computer, the computer is enabled to perform the steps of the encoding method according to the first aspect or the steps of the decoding method according to the second aspect. In other words, a computer program is provided, and when the computer program is executed, the steps of the encoding method according to the first aspect are implemented, or the steps of the decoding method according to the second aspect are implemented.

According to a ninth aspect, a computer-readable storage medium is provided. The computer-readable storage medium includes the bitstream obtained in the encoding method according to the first aspect.

Technical effect achieved in the third aspect, the fourth aspect, the fifth aspect, the sixth aspect, the seventh aspect, the eighth aspect, and the ninth aspect is similar to technical effect achieved by using a corresponding technical means in the first aspect or the second aspect. Details are not described herein again.

Technical solutions provided in embodiments of this application can have at least the following beneficial effect:

In embodiments of this application, the first whitened spectrum for the media data is whitened to obtain the second whitened spectrum, and then encoding is performed based on the second whitened spectrum. The spectral amplitude of the second whitened spectrum in the target frequency band is greater than or equal to the spectral amplitude of the first whitened spectrum in the target frequency band. It can be learned that, in this solution, the spectral amplitude of the first whitened spectrum in the target frequency band is increased, so that a difference between statistical average energy of spectral lines for different frequencies in the obtained second whitened spectrum is small. In this way, in a process of processing the second whitened spectrum by using an encoding neural network model, more spectral lines in the second whitened spectrum can be retained. To be specific, in this solution, more spectral lines can be encoded, so that more spectral features are retained, and encoding quality is improved.

### BRIEF DESCRIPTION OF DRAWINGS

FIG. 1 is a schematic diagram of an implementation environment according to an embodiment of this application;
FIG. 2 is a schematic diagram of an implementation environment of a terminal scenario according to an embodiment of this application;
FIG. 3 is a schematic diagram of an implementation environment of a transcoding scenario of a wireless or core network device according to an embodiment of this application;
FIG. 4 is a schematic diagram of an implementation environment of a broadcast and television scenario according to an embodiment of this application;
FIG. 5 is a schematic diagram of an implementation environment of a virtual reality streaming scenario according to an embodiment of this application;
FIG. 6 is a flowchart of an encoding method according to an embodiment of this application;
FIG. 7 is a flowchart of another encoding method according to an embodiment of this application;
FIG. 8 is a flowchart of still another encoding method according to an embodiment of this application;
FIG. 9 is a flowchart of a decoding method according to an embodiment of this application;
FIG. 10 is a flowchart of another decoding method according to an embodiment of this application;
FIG. 11 is a flowchart of still another decoding method according to an embodiment of this application;
FIG. 12 is a schematic diagram of spectral lines for a raw signal according to an embodiment of this application;
FIG. 13 is a schematic diagram of spectral lines obtained through processing in this solution according to an embodiment of this application;
FIG. 14 is a schematic diagram of spectral lines obtained without processing in this solution according to an embodiment of this application;
FIG. 15 is a schematic diagram of spectral lines for another raw signal according to an embodiment of this application;
FIG. 16 is another schematic diagram of spectral lines obtained through processing in this solution according to an embodiment of this application;
FIG. 17 is another schematic diagram of spectral lines obtained without processing in this solution according to an embodiment of this application;
FIG. 18 is a schematic diagram of a structure of an encoding apparatus according to an embodiment of this application;
FIG. 19 is a schematic diagram of a structure of a decoding apparatus according to an embodiment of this application; and
FIG. 20 is a schematic block diagram of an encoding and decoding apparatus according to an embodiment of this application.

### DESCRIPTION OF EMBODIMENTS

To make objectives, technical solutions, and advantages of embodiments of this application clearer, the following further describes implementations of this application in detail with reference to accompanying drawings.

Before an encoding method and a decoding method provided in embodiments of this application are described in detail, terms and implementation environments in embodiments of this application are first described.

For ease of understanding, the terms in embodiments of this application are first described.

Encoding: a process of compressing to-be-encoded media data into a bitstream. The to-be-encoded media data mainly includes an audio signal, a video signal, and an image. Encoding for an audio signal is a processing process of compressing an audio frame sequence included in a to-be-encoded audio signal into a bitstream. Encoding for a video signal is a processing process of compressing an image sequence included in a to-be-encoded video into a bitstream. Encoding for an image is a processing process of compressing a to-be-encoded image into a bitstream.

It should be noted that media data compressed into a bitstream may be referred to as encoded media data or compressed media data. For example, for an audio signal, an audio signal compressed into a bitstream may be referred to as an encoded audio signal or a compressed audio signal, a video signal compressed into a bitstream may also be referred to as an encoded video signal or a compressed video signal, and an image compressed into a bitstream may also be referred to as an encoded image or a compressed image.

Decoding: a processing process of restoring an encoded bitstream to reconstructed media data according to a specific syntax rule and processing method. Decoding for an audio bitstream is a processing process of restoring the audio bitstream to a reconstructed audio signal. Decoding for a video bitstream is a processing process of restoring the video bitstream to a reconstructed video signal. Decoding for an image bitstream is a processing process of restoring the image bitstream to a reconstructed image.

Entropy encoding: encoding during which no information is lost according to a principle of entropy, in other words, a lossless data compression method. Entropy encoding usually includes arithmetic coding (arithmetic coding), range coding (RC), Huffman (Huffman) coding, and the like.

The following describes the implementation environments in embodiments of this application.

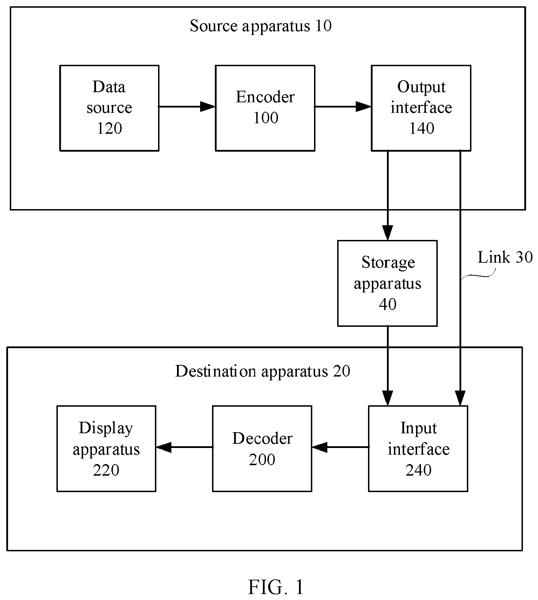

FIG. 1 is a schematic diagram of an implementation environment according to an embodiment of this application. The implementation environment includes a source apparatus 10, a destination apparatus 20, a link 30, and a storage apparatus 40. The source apparatus 10 may generate encoded media data. Therefore, the source apparatus 10 may also be referred to as a media data encoding apparatus. The destination apparatus 20 may decode the encoded media data generated by the source apparatus 10. Therefore, the destination apparatus 20 may also be referred to as a media data decoding apparatus. The link 30 may receive the encoded media data generated by the source apparatus 10, and may transmit the encoded media data to the destination apparatus 20. The storage apparatus 40 may receive the encoded media data generated by the source apparatus 10, and may store the encoded media data. In this case, the destination apparatus 20 may directly obtain the encoded media data from the storage apparatus 40. Alternatively, the storage apparatus 40 may correspond to a file server or another intermediate storage apparatus that can store the encoded media data generated by the source apparatus 10. In this case, the destination apparatus 20 may transmit, in a streaming manner, or download the encoded media data stored on the storage apparatus 40.

The source apparatus 10 and the destination apparatus 20 each may include one or more processors and a memory coupled to the one or more processors. The memory may include a random access memory (RAM), a read-only memory (ROM), an electrically erasable programmable read-only memory (EEPROM), a flash memory, any other medium that can be used to store required program code in a form of instructions or data structures and that is accessible to a computer, or the like. For example, the source apparatus 10 and the destination apparatus 20 each may include a desktop computer, a mobile computing apparatus, a notebook (for example, laptop) computer, a tablet computer, a set-top box, a telephone handset like a so-called "smartphone", a television set, a camera, a display apparatus, a digital media player, a video game console, a vehicle-mounted computer, or the like.

The link 30 may include one or more media or apparatuses that can transmit the encoded media data from the source apparatus 10 to the destination apparatus 20. In a possible implementation, the link 30 may include one or more communication media that can enable the source apparatus 10 to directly send the encoded media data to the destination apparatus 20 in real time. In this embodiment of this application, the source apparatus 10 may modulate the encoded media data according to a communication standard, where the communication standard may be a wireless communication protocol or the like; and may send modulated media data to the destination apparatus 20. The one or more communication media may include a wireless communication medium and/or a wired communication medium. For example, the one or more communication media may include a radio frequency (RF) spectrum or one or more physical transmission lines. The one or more communication media may be a part of a packet-based network. The packet-based network may be a local area network, a wide area network, a global network (for example, the Internet), or the like. The one or more communication media may include a router, a switch, a base station, another device that facilitates communication from the source apparatus 10 to the destination apparatus 20, or the like. This is not specifically limited in this embodiment of this application.

In a possible implementation, the storage apparatus 40 may store the received encoded media data sent by the source apparatus 10, and the destination apparatus 20 may directly obtain the encoded media data from the storage apparatus 40. In this case, the storage apparatus 40 may include any one of a plurality of distributed or locally accessed data storage media. For example, the any one of the plurality of distributed or locally accessed data storage media may be a hard disk drive, a Blu-ray disc, a digital versatile disc (DVD), a compact disc read-only memory (CD-ROM), a flash memory, a volatile or non-volatile memory, or any other appropriate digital storage medium for storing the encoded media data.

In a possible implementation, the storage apparatus 40 may correspond to a file server or another intermediate storage apparatus that can store the encoded media data generated by the source apparatus 10, and the destination apparatus 20 may transmit, in a streaming manner, or download the media data stored on the storage apparatus 40. The file server may be any type of server that can store the encoded media data and send the encoded media data to the destination apparatus 20. In a possible implementation, the file server may include a network server, a file transfer protocol (FTP) server, a network attached storage (NAS) apparatus, a local disk drive, or the like. The destination apparatus 20 may obtain the encoded media data through any standard data connection (including an Internet connection). The any standard data connection may include a wireless channel (for example, a Wi-Fi connection), a wired connection (for example, a digital subscriber line (DSL) or a cable modem), or a combination of a wireless channel and a wired connection suitable for obtaining the encoded media data stored on the file server. Transmission of the encoded media data from the storage apparatus 40 may be streaming transmission, download transmission, or a combination thereof.

The implementation environment shown in FIG. 1 is merely a possible implementation. In addition, technologies in embodiments of this application are not only applicable to the source apparatus 10 that can encode media data and the destination apparatus 20 that can decode encoded media data in FIG. 1, but also applicable to another apparatus that can encode media data and another apparatus that can decode encoded media data. This is not specifically limited in embodiments of this application.

In the implementation environment shown in FIG. 1, the source apparatus 10 includes a data source 120, an encoder 100, and an output interface 140. In some embodiments, the output interface 140 may include a modulator/demodulator (modem) and/or a transmitter. The transmitter may also be referred to as an emitter. The data source 120 may include an image capture apparatus (for example, a camera), an archive including previously captured media data, a feed-in interface for receiving media data from a media data content provider, and/or a computer graphics system for generating media data, or a combination of these sources of media data.

The data source 120 may send media data to the encoder 100. The encoder 100 may encode the received media data sent by the data source 120, to obtain encoded media data. The encoder may send the encoded media data to the output interface. In some embodiments, the source apparatus 10 directly sends the encoded media data to the destination apparatus 20 through the output interface 140. In another embodiment, the encoded media data may alternatively be stored on the storage apparatus 40, so that the destination apparatus 20 subsequently obtains the encoded media data for decoding and/or display.

In the implementation environment shown in FIG. 1, the destination apparatus 20 includes an input interface 240, a decoder 200, and a display apparatus 220. In some embodiments, the input interface 240 includes a receiver and/or a modem. The input interface 240 may receive encoded media data through the link 30 and/or from the storage apparatus 40, and then send the encoded media data to the decoder 200. The decoder 200 may decode the received encoded media data to obtain decoded media data. The decoder may send the decoded media data to the display apparatus 220. The display apparatus 220 may be integrated with the destination apparatus 20 or disposed outside the destination apparatus 20. Usually, the display apparatus 220 displays the decoded media data. The display apparatus 220 may be a display apparatus of any one of a plurality of types. For example, the display apparatus 220 may be a liquid crystal display (LCD), a plasma display, an organic light-emitting diode (organic light-emitting diode, OLED) display, or another type of display apparatus.

Although not shown in FIG. 1, in some aspects, the encoder 100 and the decoder 200 may be integrated with an encoder and a decoder respectively, and may include an appropriate multiplexer-demultiplexer (MUX-DEMUX) unit or other hardware and software for encoding both audio and a video in a common data stream or a separate data stream. In some embodiments, if applicable, the MUX-DEMUX unit may comply with the ITU H.223 multiplexer protocol or another protocol like the user datagram protocol (UDP).

The encoder 100 and the decoder 200 each may be any one of the following circuits: one or more microprocessors, a digital signal processor (DSP), an application-specific integrated circuit (ASIC), a fieldprogrammable gate array (FPGA), discrete logic, hardware, or any combination thereof. If technologies in embodiments of this application are partially implemented in software, an apparatus may store instructions for the software in an appropriate non-volatile computer-readable storage medium, and may execute the instructions in hardware through one or more processors, to implement technologies in embodiments of this application. Any one of the foregoing content (including hardware, software, a combination of hardware and software, and the like) may be considered as one or more processors. The encoder 100 and the decoder 200 each may be included in one or more encoders or decoders. Either the encoder or the decoder may be integrated as a part of a combined encoder/decoder (codec) in a corresponding apparatus.

The encoding method and the decoding method provided in embodiments of this application may be applied to a plurality of scenarios. The following separately describes several scenarios by using an example in which to-be-encoded media data is an audio signal.

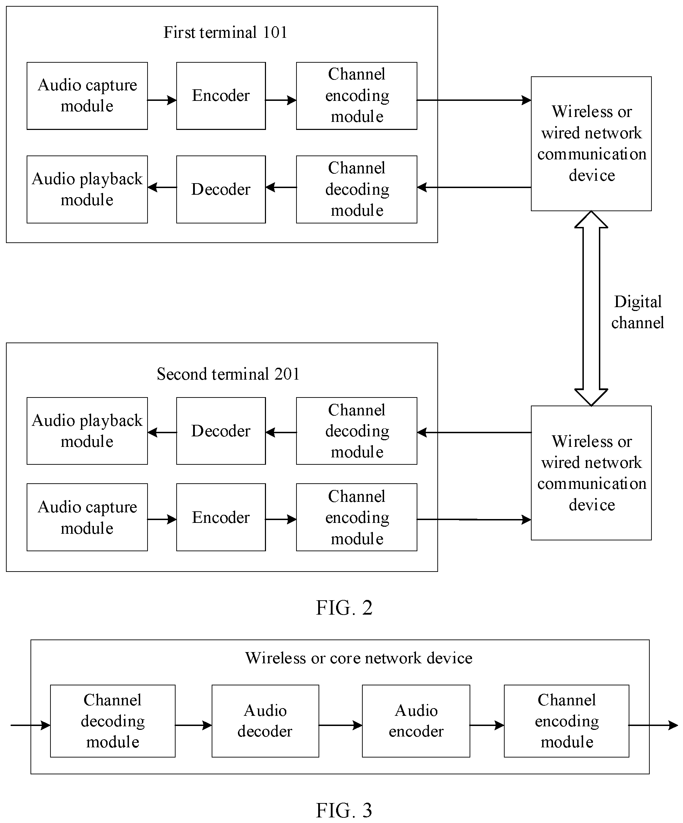

FIG. 2 is a schematic diagram of an implementation environment in which an encoding and decoding method is applied to a terminal scenario according to an embodiment of this application. The implementation environment includes a first terminal 101 and a second terminal 201. The first terminal 101 establishes a communication connection to the second terminal 201. The communication connection may be a wireless connection or a wired connection. This is not limited in this embodiment of this application.

The first terminal 101 may be a transmit-end device or a receive-end device. Similarly, the second terminal 201 may be a receive-end device or a transmit-end device. When the first terminal 101 is a transmit-end device, the second terminal 201 is a receive-end device. When the first terminal 101 is a receive-end device, the second terminal 201 is a transmit-end device.

An example in which the first terminal 101 is a transmit-end device and the second terminal 201 is a receive-end device is used below for description.

The first terminal 101 may be the source apparatus 10 in the implementation environment shown in FIG. 1. The second terminal 201 may be the destination apparatus 20 in the implementation environment shown in FIG. 1. The first terminal 101 and the second terminal 201 each include an audio capture module, an audio playback module, an encoder, a decoder, a channel encoding module, and a channel decoding module.

An audio capture module in the first terminal 101 captures an audio signal and transmits the audio signal to an encoder. The encoder encodes the audio signal by using the encoding method provided in embodiments of this application. The encoding may be referred to as source encoding. Then, to transmit the audio signal in a channel, a channel encoding module further needs to perform channel encoding, and then a bitstream obtained through encoding is transmitted in a digital channel through a wireless or wired network communication device.

The second terminal 201 receives, through a wireless or wired network communication device, the bitstream transmitted in the digital channel. A channel decoding module performs channel decoding on the bitstream. Then a decoder obtains an audio signal through decoding by using the decoding method provided in embodiments of this application. Then an audio playback module plays the audio signal.

The first terminal 101 and the second terminal 201 may be any electronic product that can perform human-computer interaction with a user through one or more of a keyboard, a touchpad, a touchscreen, a remote control, a voice interaction device, a handwriting device, or the like, for example, a personal computer (PC), a mobile phone, a smartphone, a personal digital assistant (PDA), a wearable device, a pocket personal computer PPC (pocket PC), a tablet computer, a smart automobile head unit, a smart television, or a smart speaker.

A person skilled in the art should understand that the foregoing terminals are merely examples. Other existing or possible future terminals to which embodiments of this application are applicable should also fall within the protection scope of embodiments of this application, and are included herein by reference.

FIG. 3 is a schematic diagram of an implementation environment in which an encoding and decoding method is applied to a transcoding scenario of a wireless or core network device according to an embodiment of this application. The implementation environment includes a channel decoding module, an audio decoder, an audio encoder, and a channel encoding module.

The audio decoder may be a decoder that uses the decoding method provided in embodiments of this application, or may be a decoder that uses another decoding method. The audio encoder may be an encoder that uses the encoding method provided in embodiments of this application, or may be an encoder that uses another encoding method. When the audio decoder is a decoder that uses the decoding method provided in embodiments of this application, the audio encoder is an encoder that uses another encoding method. When the audio decoder is a decoder that uses another decoding method, the audio encoder is an encoder that uses the encoding method provided in embodiments of this application.

In a first case, the audio decoder is a decoder that uses the decoding method provided in embodiments of this application, and the audio encoder is an encoder that uses another encoding method.

In this case, the channel decoding module is configured to perform channel decoding on a received bitstream. Then the audio decoder is configured to perform source decoding by using the decoding method provided in embodiments of this application. Then the audio encoder performs encoding according to the another encoding method, to implement conversion from one format to another format, namely, transcoding. Then transmission is performed after channel encoding.

In a second case, the audio decoder is a decoder that uses another decoding method, and the audio encoder is an encoder that uses the encoding method provided in embodiments of this application.

In this case, the channel decoding module is configured to perform channel decoding on a received bitstream. Then the audio decoder is configured to perform source decoding by using the another decoding method. Then the audio encoder performs encoding by using the encoding method provided in embodiments of this application, to implement conversion from one format to another format, namely, transcoding. Then transmission is performed after channel encoding.

The wireless device may be a wireless access point, a wireless router, a wireless connector, or the like. The core network device may be a mobility management entity, a gateway, or the like.

A person skilled in the art should understand that the foregoing wireless devices or core network devices are merely examples. Other existing or possible future wireless or core network devices to which embodiments of this application are applicable should also fall within the protection scope of embodiments of this application, and are included herein by reference.

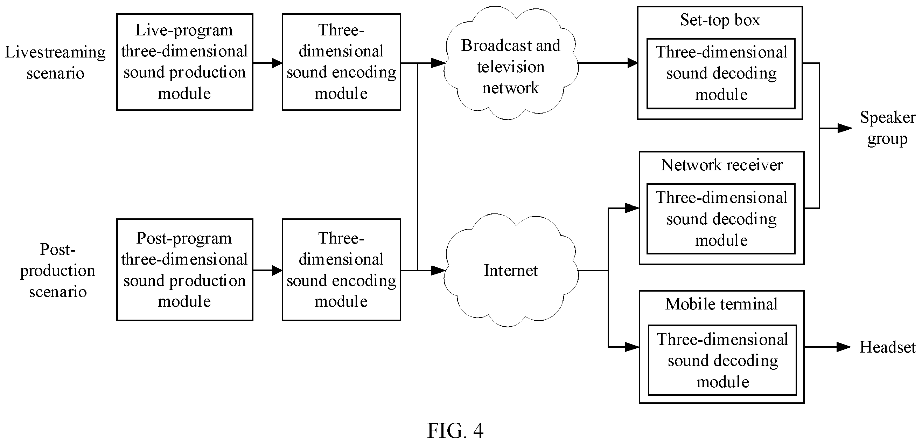

FIG. 4 is a schematic diagram of an implementation environment in which an encoding and decoding method is applied to a broadcast and television scenario according to an embodiment of this application. The broadcast and television scenario includes a livestreaming scenario and a post-production scenario. In the livestreaming scenario, the implementation environment includes a live-program three-dimensional sound production module, a three-dimensional sound encoding module, a set-top box, and a speaker group. The set-top box includes a three-dimensional sound decoding module. In the post-production scenario, the implementation environment includes a post-program three-dimensional sound production module, a three-dimensional sound encoding module, a network receiver, a mobile terminal, a headset, and the like.

In the livestreaming scenario, the live-program three-dimensional sound production module produces a three-dimensional sound signal. The three-dimensional sound signal is encoded by using the encoding method in embodiments of this application to obtain a bitstream. The bitstream is transmitted to a user side through a broadcast and television network, and is decoded by the three-dimensional sound decoding module in the set-top box decodes by using the decoding method provided in embodiments of this application, to reconstruct a three-dimensional sound signal. The speaker group plays the reconstructed three-dimensional sound signal. Alternatively, the bitstream is transmitted to the user side through the Internet, and is decoded by a three-dimensional sound decoding module in the network receiver by using the decoding method provided in embodiments of this application, to reconstruct a three-dimensional sound signal, and the speaker group plays the reconstructed three-dimensional sound signal. Alternatively, the bitstream is transmitted to the user side through the Internet, and is decoded by a three-dimensional sound decoding module in the mobile terminal by using the decoding method provided in embodiments of this application, to reconstruct a three-dimensional sound signal, and the headset plays the reconstructed three-dimensional sound signal.

In the post-production scenario, the post-program three-dimensional sound production module produces a three-dimensional sound signal. The three-dimensional sound signal is encoded by using the encoding method in embodiments of this application to obtain a bitstream. The bitstream is transmitted to a user side through a broadcast and television network, and is decoded by the three-dimensional sound decoding module in the set-top box decodes by using the decoding method provided in embodiments of this application, to reconstruct a three-dimensional sound signal. The speaker group plays the reconstructed three-dimensional sound signal. Alternatively, the bitstream is transmitted to the user side through the Internet, and is decoded by a three-dimensional sound decoding module in the network receiver by using the decoding method provided in embodiments of this application, to reconstruct a three-dimensional sound signal, and the speaker group plays the reconstructed three-dimensional sound signal. Alternatively, the bitstream is transmitted to the user side through the Internet, and is decoded by a three-dimensional sound decoding module in the mobile terminal by using the decoding method provided in embodiments of this application, to reconstruct a three-dimensional sound signal, and the headset plays the reconstructed three-dimensional sound signal.

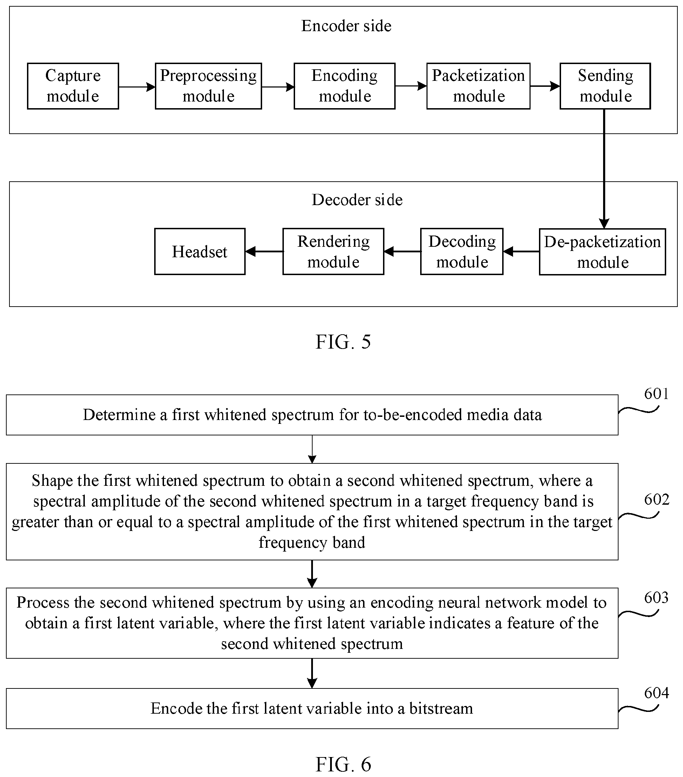

FIG. 5 is a schematic diagram of an implementation environment in which an encoding and decoding method is applied to a virtual reality streaming scenario according to an embodiment of this application. The implementation environment includes an encoder side and a decoder side. The encoder side includes a capture module, a preprocessing module, an encoding module, a packetization module, and a sending module. The decoder side includes a de-packetization module, a decoding module, a rendering module, and a headset.

The capture module captures an audio signal. Then the preprocessing module performs a preprocessing operation. The preprocessing operation includes filtering out a low-frequency part from the signal usually by using 20 Hz or 50 Hz as a demarcation point, extracting orientation information from the signal, and the like. Then the encoding module performs encoding by using the encoding method provided in embodiments of this application. After the encoding, the packetization module performs packetization. Then the sending module sends a packetized signal to the decoder side.

The de-packetization module on the decoder side first performs de-packetization. Then the decoding module performs decoding by using the decoding method provided in embodiments of this application. Then the rendering module performs binaural rendering on a decoded signal. A rendered signal is mapped to a headset of a listener. The headset may be an independent headset, or may be a headset on a virtual reality-based glasses device.

It should be noted that service scenarios described in embodiments of this application are intended to describe technical solutions in embodiments of this application more clearly, and do not constitute a limitation on technical solutions provided in embodiments of this application. A person of ordinary skill in the art can know that technical solutions provided in embodiments of this application are also applicable to similar technical problems with emergence of new service scenarios.

The following describes in detail the encoding method and the decoding method provided in embodiments of this application. It should be noted that, with reference to the implementation environment shown in FIG. 1, any one of the following encoding methods may be performed by the encoder 100 in the source apparatus 10, and any one of the following decoding methods may be performed by the decoder 200 in the destination apparatus 20.

FIG. 6 is a flowchart of an encoding method according to an embodiment of this application. The method is applied to an encoder-side device. As shown in FIG. 6, the method includes the following steps.

Step 601: Determine a first whitened spectrum for to -be-encoded media data.

The to-be-encoded media data is an audio signal, a video signal, an image, or the like. In addition, the to-be-encoded media data may be in any form. This is not limited in this embodiment of this application.

In this embodiment of this application, the to-be-encoded media data may be time-domain media data. Time-frequency transformation is performed on the time-domain media data to obtain frequency-domain media data, and the frequency-domain media data is whitened to obtain the first whitened spectrum for the media data. Alternatively, the to-be-encoded media data may be frequency-domain media data obtained by performing time-frequency transformation on time-domain media data, and the to-be-encoded media data is whitened to obtain the first whitened spectrum for the media data.

Optionally, if the to-be-encoded media data is time-domain media data, the to-be-encoded media data may alternatively be preprocessed first to obtain preprocessed time-domain media data, and then time-frequency transformation is performed on the preprocessed time-domain media data to obtain frequency-domain media data. The preprocessing may be windowing, temporal noise shaping (TNS), channel downmixing, or the like. Alternatively, the frequency-domain media data obtained through time-frequency transformation may be preprocessed, and then preprocessed frequency-domain media data is whitened to obtain the first whitened spectrum. The preprocessing may be frequency-domain noise shaping (FDNS) or the like.

There may be a plurality of manners of time-frequency transformation in this embodiment of this application. For example, the time-frequency transformation may be modified discrete cosine transform (MDCT), fast Fourier transform (FFT), or quadrature mirror filter (QMF) filtering, or may be time-frequency transformation in another manner. This is not limited in this embodiment of this application.

In addition, there may also be a plurality of manners of whitening. This is not limited in this embodiment of this application. For example, linear predictive coding (LPC) analysis is performed on the frequency-domain media data to obtain an LPC coefficient, and the frequency-domain media data is whitened based on the LPC coefficient to obtain the first whitened spectrum for the media data. Alternatively, the LPC coefficient is converted into a frequency-domain whitening factor, and the whitening factor is applied to the frequency-domain media data to obtain the first whitened spectrum. For another example, the frequency-domain media data is divided into a plurality of different frequency bands, envelope information of a corresponding frequency band is obtained based on spectral energy of the frequency-domain media data in each frequency band, and the frequency-domain media data is processed based on the envelope information of each frequency band to obtain the first whitened spectrum. In some embodiments, a whitened spectrum is also referred to as a residual spectrum, a residual signal, or the like.

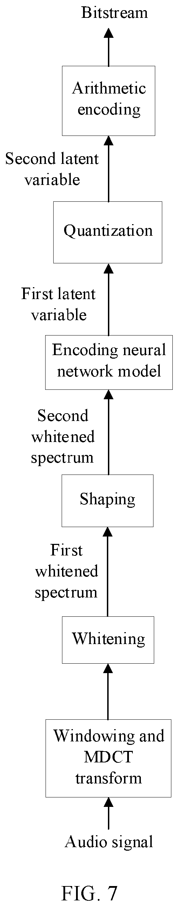

FIG. 7 is a block diagram of an example encoding method according to an embodiment of this application. In FIG. 7, an example in which to-be-encoded media data is an audio signal is used. First, windowing is performed on the audio signal to obtain an audio signal of a current frame. MDCT transform is performed on the audio signal of the current frame to obtain a frequency-domain signal of the current frame. The frequency-domain signal of the current frame is whitened to obtain a first whitened spectrum. Whitening may be performed in any one of the manners described above.

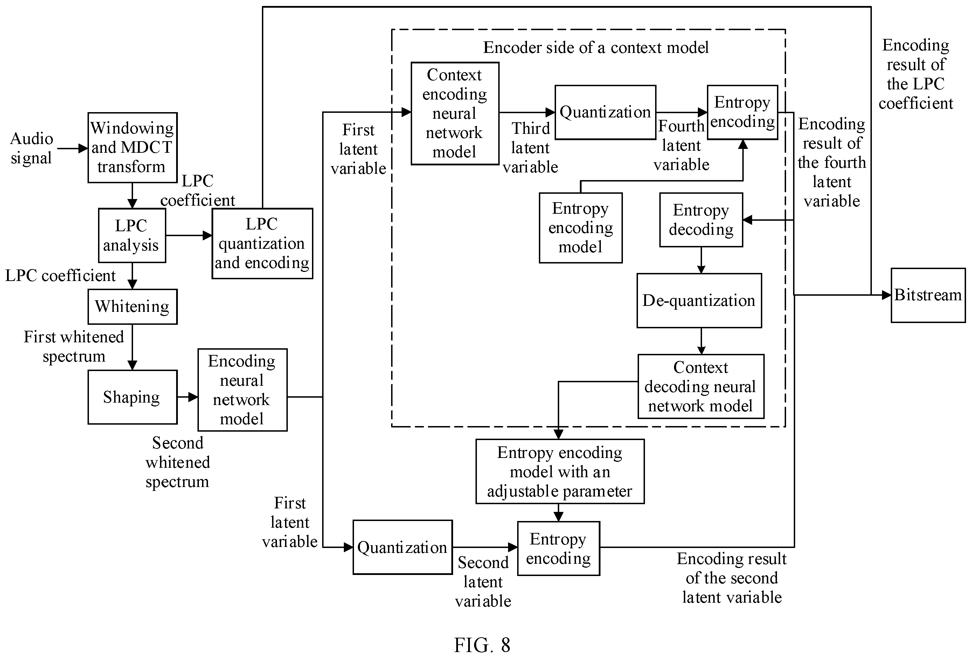

FIG. 8 is a block diagram of another example encoding method according to an embodiment of this application. In FIG. 8, an example in which to-be-encoded media data is an audio signal is also used. First, windowing is performed on the audio signal to obtain an audio signal of a current frame. MDCT transform is performed on the audio signal of the current frame to obtain a frequency-domain signal of the current frame. LPC analysis is performed on the frequency-domain signal of the current frame to obtain an LPC coefficient. The frequency-domain signal of the current frame is whitened based on the LPC coefficient to obtain a first whitened spectrum.

Step 602: Shape the first whitened spectrum to obtain a second whitened spectrum, where a spectral amplitude of the second whitened spectrum in a target frequency band is greater than or equal to a spectral amplitude of the first whitened spectrum in the target frequency band.

In this embodiment of this application, the first whitened spectrum is shaped to obtain the second whitened spectrum, and the spectral amplitude of the second whitened spectrum in the target frequency band is greater than or equal to the spectral amplitude of the first whitened spectrum in the target frequency band. To be specific, a difference between statistical average energy of spectral lines in the second whitened spectrum is small, and to some extent, it can be considered that a dynamic range of statistical average energy distribution of the second whitened spectrum is smaller than a dynamic range of statistical average energy distribution of the first whitened spectrum. The spectral amplitude is an absolute value or a modulus of a spectral value of a frequency. In this embodiment of this application, the spectral value may be an MDCT coefficient, an FFT coefficient, or a QMF coefficient. In some embodiments, the spectral value is also referred to as a spectral coefficient or the like.

A frequency band, in the first whitened spectrum, that needs to be shaped is a target frequency band corresponding to the media data. Optionally, the target frequency band is determined based on one or more factors of a sampling rate, a channel quantity, an encoding rate, encoding bandwidth, and an encoding mode that correspond to the media data. To be specific, in this embodiment of this application, there are one or more reference factors for determining the target frequency band. For example, for different media data, if sampling rates are different, corresponding target frequency bands may be different; if channel quantities are different, corresponding target frequency bands may be different; if encoding rates are different, corresponding target frequency bands may be different; if encoding bandwidth is different, corresponding target frequency bands may be different; or if encoding modes are different, corresponding target frequency bands may be different.

In this embodiment of this application, the target frequency band covers an entire range or a partial range of a spectral range of the media data, and the spectral range of the media data is a spectral range of the first whitened spectrum. In addition, the target frequency band is preset, or the target frequency band is determined based on the first whitened spectrum.

If the target frequency band is preset, the target frequency band may be preset based on one or more factors of a sampling rate, a channel quantity, an encoding rate, encoding bandwidth, and an encoding mode that correspond to the to-be-encoded media data; or some frequency bands with low spectral energy are determined through statistical analysis on spectral energy distribution of a large quantity of media data samples, and the frequency bands with low spectral energy are set as the target frequency band. For example, assuming that the spectral range of the media data is 0 kHz to 8.25 kHz (kilohertz), the target frequency band may be preset to 4 kHz to 8.25 kHz; or assuming that the spectral range of the media data is 0 kHz to 16 kHz, and the target frequency band may be preset to include 4 kHz to 8 kHz, and 12 kHz to 14 kHz.

If the target frequency band is determined based on the first whitened spectrum, the target frequency band is determined based on the first whitened spectrum before the first whitened spectrum is shaped to obtain the second whitened spectrum. An implementation of determining the target frequency band based on the first whitened spectrum is as follows: dividing the spectral range of the media data into a first quantity of first frequency subbands; determining an average value of spectral energy of the first whitened spectrum in each of the first quantity of first frequency subbands to obtain a first quantity of average values of spectral energy of frequency subbands; determining an average value of spectral energy of the first whitened spectrum within the spectral range; and determining, based on the average value of spectral energy and the first quantity of average values of spectral energy of frequency subbands, a first frequency subband included in the target frequency band. The first quantity may be preset.

An implementation of determining, based on the average value of spectral energy and the first quantity of average values of spectral energy of frequency subbands, the first frequency subband included in the target frequency band is as follows: using a first frequency subband corresponding to an average value of spectral energy, in the first quantity of average values of spectral energy of frequency subbands, whose difference from the average value of spectral energy exceeds a specified threshold as the first frequency subband included in the target frequency band. To be specific, a first frequency subband with low spectral energy is selected based on an energy distribution status of the first whitened spectrum for the to-be-encoded media data, and the selected first frequency subband is included in the target frequency band. Certainly, in addition to the manner of calculating the difference and comparing the difference with the specified threshold, the first frequency subband included in the target frequency band may alternatively be determined in another manner. This is not limited in this embodiment of this application.

It should be noted that, if the target frequency band is determined based on the first whitened spectrum, the encoder side encodes information indicating the target frequency band into a bitstream.

After the target frequency band is determined, the target frequency band in the first whitened spectrum is shaped to obtain the second whitened spectrum. In this embodiment of this application, the first whitened spectrum is shaped based on a gain adjustment factor to obtain the second whitened spectrum.

Optionally, the target frequency band includes a second quantity of second frequency subbands within the spectral range of the media data, and the gain adjustment factor includes an adjustment factor corresponding to each of the second quantity of second frequency subbands. If the target frequency band is determined based on the first whitened spectrum, any one of the second quantity of second frequency subbands may be one first frequency subband included in the target frequency band, or any second frequency subband may be a frequency band including a plurality of continuous first frequency subbands included in the target frequency band. To be specific, the second quantity of second frequency subbands is determined based on first frequency subbands included in the target frequency band. For example, a plurality of continuous first frequency subbands included in the target frequency band are integrated into one second frequency subband, and discontinuous first frequency subbands included in the target frequency band each serve as one second frequency subband.

In this embodiment of this application, an implementation of shaping the first whitened spectrum based on the gain adjustment factor to obtain the second whitened spectrum is as follows: determining a spectral value of the first whitened spectrum at a frequency in each of the second quantity of second frequency subbands, and adjusting a spectral value of the first whitened spectrum at a frequency in a corresponding second frequency subband based on an adjustment factor corresponding to each of the second quantity of second frequency subbands, to obtain the second whitened spectrum.

For example, a first to-be-adjusted frequency subband is any one of the second quantity of second frequency subbands. For the first to-be-adjusted frequency subband, if an adjustment factor corresponding to the first to-be-adjusted frequency subband is greater than 1, a spectral value of the first whitened spectrum at a frequency in the first to-be-adjusted frequency subband is multiplied by a corresponding adjustment factor to obtain a spectral value of the second whitened spectrum at a frequency in the first to-be-adjusted frequency subband; or if an adjustment factor corresponding to the first to-be-adjusted frequency subband is greater than 0 and less than or equal to 1, a spectral value of the first whitened spectrum at a frequency in the first to-be-adjusted frequency subband is divided by a corresponding adjustment factor to obtain a spectral value of the second whitened spectrum at a frequency in the first to-be-adjusted frequency subband. It should be noted that, the first whitened spectrum is preset to be adjusted through multiplication by the adjustment factor, or the first whitened spectrum is preset to be adjusted through division by the adjustment factor, that is, multiplication or division is directly performed based on the setting during encoding.

It should be noted that adjustment factors corresponding to all of the second quantity of second frequency subbands may be determined in a same manner or different manners, and the adjustment factor corresponding to the first to-be-adjusted frequency subband of the second quantity of second frequency subbands meets the following condition: frequencies in the first to-be-adjusted frequency subband correspond to one adjustment factor, and the adjustment factor is a preset value; or frequencies in the first to-be-adjusted frequency subband correspond to different adjustment factors, and adjustment factors corresponding to at least a part of the frequencies are determined through linear interpolation; or adjustment factors corresponding to frequencies in the first to-be-adjusted frequency subband are different, and the adjustment factors corresponding to the frequencies are determined according to a preset function. To be specific, a first implementation of determining the adjustment factor corresponding to the first to-be-adjusted frequency subband is setting the corresponding adjustment factor to a preset value, a second implementation is determining the corresponding adjustment factor through linear interpolation, and a third implementation is determining the corresponding adjustment factor according to the preset function. The following separately describes the three implementations of determining the adjustment factor corresponding to the first to-be-adjusted frequency subband.

First implementation: The adjustment factor corresponding to the first to-be-adjusted frequency subband is set to a preset value.

For example, the adjustment factor corresponding to the first to-be-adjusted frequency subband is set to 0.5, 1.5, or 2. In some embodiments, the adjustment factor being 2 is equivalent to an increase of 3 dB. To be specific, if the adjustment factor is 2, spectral energy of a corresponding frequency can be increased by approximately 3 dB. Certainly, when a same adjustment factor is applied to first whitened spectra for different media data, spectral energy increase statuses of obtained second whitened spectra may also be different.

Second implementation: Adjustment factors corresponding to at least a part of the frequencies in the first to-be-adjusted frequency subband are determined through linear interpolation.

The adjustment factors corresponding to the at least a part of the frequencies are determined in the following manner: determining a start adjustment factor corresponding to the first to-be-adjusted frequency subband; determining a stop adjustment factor corresponding to the first to-be-adjusted frequency subband; and determining, based on the start adjustment factor and the stop adjustment factor through linear interpolation, the adjustment factors corresponding to the at least a part of the frequencies.

To be specific, during linear interpolation, a start adjustment factor and a stop adjustment factor are needed; a linear relationship is determined based on the start adjustment factor, the stop adjustment factor, a spectral value of a frequency corresponding to the start adjustment factor, and a spectral value of a frequency corresponding to the stop adjustment factor; and adjustment factors corresponding to at least a part of the frequencies in the first to-be-adjusted frequency subband are determined based on the linear relationship through linear interpolation.

Optionally, the at least a part of the frequencies do not include a start frequency or a stop frequency of the first to-be-adjusted frequency subband, an adjustment factor corresponding to the start frequency of the first to-be-adjusted frequency subband is the start adjustment factor, and the adjustment factor corresponding to the first to-be-adjusted frequency subband is the stop adjustment factor.

Both the start adjustment factor and the stop adjustment factor are preset values; or the start adjustment factor is a preset value, and the stop adjustment factor is a non-preset value; or the start adjustment factor is a non-preset value, and the stop adjustment factor is a preset value; or both the start adjustment factor and the stop adjustment factor are non-preset values. Based on this, there are a plurality of solutions of linear interpolation in the second implementation. The following describes three of the solutions in detail.

First solution of linear interpolation: Both the start adjustment factor and the stop adjustment factor are preset values.

To be specific, the start adjustment factor and the stop adjustment factor that correspond to the first to-be-adjusted frequency subband are preset. Optionally, it is determined that the start adjustment factor is the adjustment factor corresponding to the start frequency of the first to-be-adjusted frequency subband, and it is determined that the stop adjustment factor is the adjustment factor corresponding to the stop frequency of the first to-be-adjusted frequency subband. Adjustment factors corresponding to frequencies in the first to-be-adjusted frequency subband other than the start frequency and the stop frequency are determined through linear interpolation based on the adjustment factor corresponding to the start frequency of the first to-be-adjusted frequency subband and the adjustment factor corresponding to the stop frequency of the first to-be-adjusted frequency subband. It should be noted that the adjustment factor corresponding to the start frequency of the first to-be-adjusted frequency subband and the adjustment factor corresponding to the stop frequency of the first to-be-adjusted frequency subband are essentially preset. In this way, only the adjustment factors corresponding to the frequencies in the first to-be-adjusted frequency subband other than the start frequency and the stop frequency further need to be determined during linear interpolation.

For example, it is assumed that the first to-be-adjusted frequency subband is 3 kHz to 8.25 kHz, corresponding to a 128th frequency to a 352nd frequency. A start adjustment factor and a stop adjustment factor that correspond to 3 kHz to 8.25 kHz are preset to 1.0 and 2.2 respectively, and 1.0 and 2.2 serve as adjustment factors corresponding to the 128th frequency and the 352nd frequency respectively. Then adjustment factors corresponding to frequencies within 3 kHz to 8.25 kHz other than the 128th frequency and the 352nd frequency are determined through linear interpolation.

Alternatively, the start adjustment factor and the stop adjustment factor that correspond to the first to-be-adjusted frequency subband are preset, and adjustment factors corresponding to frequencies in the first to-be-adjusted frequency subband are determined based on the start adjustment factor and the stop adjustment factor through linear interpolation. For example, it is assumed that the first to-be-adjusted frequency subband is 3 kHz to 8.25 kHz, corresponding to a 128th frequency to a 352nd frequency. A start adjustment factor and a stop adjustment factor that correspond to 3 kHz to 8.25 kHz are preset to 1.0 and 2.2 respectively, and 1.0 and 2.2 correspond to a 127th frequency and a 353rd frequency respectively. Adjustment factors corresponding to the 128th frequency to the 352nd frequency within 3 kHz to 8.25 kHz are determined based on the correspondence through linear interpolation.

Second solution of linear interpolation: The stop adjustment factor is a non-preset value.

If the stop adjustment factor is a non-preset value, the stop adjustment factor may be an adjustment factor corresponding to a start frequency of a second to-be-adjusted frequency subband, the second to-be-adjusted frequency subband is a second frequency subband located after the first to-be-adjusted frequency subband in the second quantity of second frequency subbands, and the first to-be-adjusted frequency subband and the second to-be-adjusted frequency subband are continuous. In this embodiment of this application, an implementation of determining the stop adjustment factor is as follows: obtaining an adjustment factor corresponding to a start frequency of a second to-be-adjusted frequency subband as the stop adjustment factor.

In the second solution, the start adjustment factor corresponding to the first to-be-adjusted frequency subband may be preset, and then the adjustment factor corresponding to the start frequency of the second to-be-adjusted frequency subband is obtained as the stop adjustment factor. It is determined that the start adjustment factor is the adjustment factor corresponding to the start frequency of the first to-be-adjusted frequency subband, and it is determined that the stop adjustment factor is the adjustment factor corresponding to the stop frequency of the first to-be-adjusted frequency subband. Then adjustment factors corresponding to frequencies in the first to-be-adjusted frequency subband other than the start frequency and the stop frequency are determined through linear interpolation based on the adjustment factor corresponding to the start frequency of the first to-be-adjusted frequency subband and the adjustment factor corresponding to the stop frequency.

To be specific, because the second to-be-adjusted frequency subband is a frequency band that is located after the first to-be-adjusted frequency subband and that is continuous with the first to-be-adjusted frequency subband, the adjustment factor corresponding to the start frequency of the second to-be-adjusted frequency subband may be essentially directly used as the adjustment factor corresponding to the stop frequency of the first to-be-adjusted frequency subband. In this way, only the adjustment factors corresponding to the frequencies in the first to-be-adjusted frequency subband other than the start frequency and the stop frequency further need to be determined during linear interpolation.

For example, the first to-be-adjusted frequency subband is 4 kHz to 6 kHz, corresponding to a 171st frequency to a 256th frequency, and the second to-be-adjusted frequency subband is 6 kHz to 8.25 kHz, corresponding to a 257th frequency to a 352nd frequency. A start adjustment factor corresponding to 4 kHz to 6 kHz is preset to 1.5, 1.5 serves as an adjustment factor corresponding to the 171st frequency, and an adjustment factor corresponding to a start frequency (namely, the 257th frequency) of 6 kHz to 8.25 kHz is obtained. Assuming that the adjustment factor corresponding to the 257th frequency is 2, 2 serves as an adjustment factor corresponding to the 256th frequency, and then adjustment factors corresponding to frequencies within 4 kHz to 6 kHz other than the 171st frequency and the 256th frequency are determined through linear interpolation.

Alternatively, after the adjustment factor corresponding to the start frequency of the second to-be-adjusted frequency subband is obtained as the stop adjustment factor, adjustment factors corresponding to frequencies in the first to-be-adjusted frequency subband other than the start frequency are determined through linear interpolation based on the adjustment factor corresponding to the start frequency of the first to-be-adjusted frequency subband and the stop adjustment factor. To be specific, because the second to-be-adjusted frequency subband is a frequency band that is located after the first to-be-adjusted frequency subband and that is continuous with the first to-be-adjusted frequency subband, the adjustment factors corresponding to the frequencies in the first to-be-adjusted frequency subband other than the start frequency may be essentially determined through linear interpolation based on the adjustment factor corresponding to the start frequency of the first to-be-adjusted frequency subband and the adjustment factor corresponding to the start frequency of the second to-be-adjusted frequency subband.

Still, for example, the first to-be-adjusted frequency subband is 4 kHz to 6 kHz, corresponding to a 171st frequency to a 256th frequency, and the second to-be-adjusted frequency subband is 6 kHz to 8.25 kHz, corresponding to a 257th frequency to a 352nd frequency. A start adjustment factor corresponding to 4 kHz to 6 kHz is preset to 1.5, 1.5 serves as an adjustment factor corresponding to the 171st frequency, and an adjustment factor corresponding to a start frequency (namely, the 257th frequency) of 6 kHz to 8.25 kHz is obtained. Assuming that the adjustment factor corresponding to the 257th frequency is 2, adjustment factors corresponding to frequencies within 4 kHz to 6 kHz (to be specific, the 171st frequency to the 256th frequency) other than the 171st frequency are determined through linear interpolation.

Optionally, the adjustment factor corresponding to the start frequency of the second to-be-adjusted frequency subband may be preset, determined through linear interpolation, or determined according to a preset function. This is not limited in this embodiment of this application.

Third solution of linear interpolation: The start adjustment factor is a non-preset value.

If the start adjustment factor is a non-preset value, the start adjustment factor may be an adjustment factor corresponding to a stop frequency of a third to-be-adjusted frequency subband, the third to-be-adjusted frequency subband is a second frequency subband located before the first to-be-adjusted frequency subband in the second quantity of second frequency subbands, and the first to-be-adjusted frequency subband and the third to-be-adjusted frequency subband are continuous. In this embodiment of this application, an implementation of determining the start adjustment factor is as follows: obtaining an adjustment factor corresponding to a stop frequency of a third to-be-adjusted frequency subband as the start adjustment factor.

In the third solution, the stop adjustment factor corresponding to the first to-be-adjusted frequency subband may be preset, and then the adjustment factor corresponding to the stop frequency of the third to-be-adjusted frequency subband is obtained as the start adjustment factor. It is determined that the start adjustment factor is the adjustment factor corresponding to the start frequency of the first to-be-adjusted frequency subband, and it is determined that the stop adjustment factor is the adjustment factor corresponding to the stop frequency of the first to-be-adjusted frequency subband. Adjustment factors corresponding to frequencies in the first to-be-adjusted frequency subband other than the start frequency and the stop frequency are determined through linear interpolation based on the adjustment factor corresponding to the start frequency of the first to-be-adjusted frequency subband and the adjustment factor corresponding to the stop frequency of the first to-be-adjusted frequency subband.

To be specific, because the third to-be-adjusted frequency subband is a frequency band that is located before the first to-be-adjusted frequency subband and that is continuous with the first to-be-adjusted frequency subband, the adjustment factor corresponding to the stop frequency of the third to-be-adjusted frequency subband may be essentially directly used as the adjustment factor corresponding to the start frequency of the first to-be-adjusted frequency subband. In this way, only the adjustment factors corresponding to the frequencies in the first to-be-adjusted frequency subband other than the start frequency and the stop frequency further need to be determined during linear interpolation.

Alternatively, after the adjustment factor corresponding to the stop frequency of the third to-be-adjusted frequency subband is obtained as the start adjustment factor, adjustment factors corresponding to frequencies in the first to-be-adjusted frequency subband other than the stop frequency are determined through linear interpolation based on the start adjustment factor and the adjustment factor corresponding to the stop frequency of the first to-be-adjusted frequency subband. To be specific, because the third to-be-adjusted frequency subband is a frequency band that is located before the first to-be-adjusted frequency subband and that is continuous with the first to-be-adjusted frequency subband, the adjustment factors corresponding to the frequencies in the first to-be-adjusted frequency subband other than the stop frequency may be essentially determined through linear interpolation based on the adjustment factor corresponding to the stop frequency of the third to-be-adjusted frequency subband and the adjustment factor corresponding to the stop frequency of the first to-be-adjusted frequency subband.

Optionally, the adjustment factor corresponding to the stop frequency of the third to-be-adjusted frequency subband may be preset, determined through linear interpolation, or determined according to a preset function. This is not limited in this embodiment of this application.

It can be learned that a principle of the second solution is similar to that of the third solution. In some embodiments, it is assumed that the target frequency band includes a plurality of second frequency subbands, in other words, the second quantity is greater than 1, the plurality of second frequency subbands are continuous, and the second solution or the third solution are used for all the plurality of second frequency subbands. In this case, an adjustment factor corresponding to a start frequency of each of the plurality of second frequency subbands may be preset, an adjustment factor corresponding to a stop frequency of a last one of the plurality of second frequency subbands is set, and adjustment factors of frequencies in each second frequency subband other than a frequency with a corresponding preset adjustment factor are determined through linear interpolation based on the adjustment factor corresponding to the start frequency of each second frequency subband and the adjustment factor corresponding to the stop frequency of the last second frequency subband. Alternatively, an adjustment factor corresponding to a stop frequency of each of the plurality of second frequency subbands is preset, an adjustment factor corresponding to a start frequency of a first one of the plurality of second frequency subbands is preset, and adjustment factors of frequencies in each second frequency subband other than a frequency with a corresponding preset adjustment factor are determined through linear interpolation based on the adjustment factor corresponding to the stop frequency of each second frequency subband and the adjustment factor corresponding to the start frequency of the first second frequency subband.

Third implementation: The adjustment factor corresponding to the first to-be-adjusted frequency subband is determined according to the preset function.

In this embodiment of this application, if the adjustment factors corresponding to the frequencies in the first to-be-adjusted frequency subband are determined according to the preset function, before the first whitened spectrum is shaped based on the gain adjustment factor to obtain the second whitened spectrum, a preset function corresponding to the first to-be-adjusted frequency subband is obtained from one or more stored preset functions, a function argument range corresponding to the first to-be-adjusted frequency subband is obtained, and the adjustment factors corresponding to the frequencies in the first to-be-adjusted frequency subband are determined according to the preset function corresponding to the first to-be-adjusted frequency subband and based on the function argument range corresponding to the first to-be-adjusted frequency subband.

For example, values of arguments in a one-to-one correspondence with the frequencies in the first to-be-adjusted frequency subband are determined within the function argument range based on a quantity of frequencies in the first to-be-adjusted frequency subband, and function values corresponding to the determined values of the arguments are determined according to the preset function corresponding to the first to-be-adjusted frequency subband, that is, the adjustment factors corresponding to the frequencies in the first to-be-adjusted frequency subband are obtained. In other words, the determined function values are the calculated adjustment factors.

Each of the one or more preset functions corresponds to one second frequency subband. The one or more preset functions are the same or different. Function argument ranges of the preset functions may also be the same or different. This is not limited in this embodiment of this application. Optionally, the preset function corresponding to the first to-be-adjusted frequency subband is a non-linear function. In this way, a spectral value of a frequency in the first to-be-adjusted frequency subband is subsequently adjusted based on a non-linear relationship. For example, the preset function is a quadratic function or a log function. If the preset function corresponding to the first to-be-adjusted frequency subband is a linear function, a spectral value of a frequency in the first to-be-adjusted frequency subband is subsequently adjusted based on a linear relationship. A principle thereof is essentially similar to a principle of linear interpolation.

The foregoing describes three implementations of determining an adjustment factor. It should be noted that the foregoing three implementations may be used separately or in combination. To be specific, for any second frequency subband, a corresponding adjustment factor may be determined in any manner. For example, an adjustment factor corresponding to a second frequency subband is a preset value, and an adjustment factor corresponding to another second frequency subband is determined through linear interpolation; or adjustment factors corresponding to the two second frequency subbands are both preset values. In addition to the foregoing three implementations, an adjustment factor may alternatively be determined in other manners, provided that a spectral amplitude in the target frequency band can be increased by using the determined adjustment factor.

For example, the adjustment factor corresponding to the first to-be-adjusted frequency subband and the adjustment factor corresponding to the second to-be-adjusted frequency subband are determined in different manners. The frequencies in the first to-be-adjusted frequency subband correspond to one adjustment factor, and the adjustment factor is a preset value. The second to-be-adjusted frequency subband is a frequency band that is located after the first to-be-adjusted frequency subband and that is continuous with the first to-be-adjusted frequency subband. The frequencies in the second to-be-adjusted frequency subband correspond to different adjustment factors, and adjustment factors corresponding to at least a part of the frequencies are determined through linear interpolation.

It is assumed that the first to-be-adjusted frequency subband is 0 kHz to 3 kHz, corresponding to a 0th frequency to a 127th frequency. An adjustment factor corresponding to the frequencies in the first to-be-adjusted frequency subband is preset to 1.0. It is assumed that the second to-be-adjusted frequency subband is 3 kHz to 8.25 kHz, corresponding to a 128th frequency to a 352nd frequency. A start adjustment factor and a stop adjustment factor that correspond to 3 kHz to 8.25 kHz are preset to 1.0 and 2.2 respectively, and 1.0 and 2.2 serve as adjustment factors corresponding to the 128th frequency and the 352nd frequency respectively. Then adjustment factors corresponding to frequencies within 3 kHz to 8.25 kHz other than the 128th frequency and the 352nd frequency are determined through linear interpolation.

After the adjustment factor corresponding to each second frequency subband is determined, as shown in FIG. 7 and FIG. 8, a spectral value of the first whitened spectrum at each frequency in the target frequency band is shaped based on the determined adjustment factor to obtain the second whitened spectrum.

Optionally, before the first whitened spectrum is shaped to obtain the second whitened spectrum, whether the first whitened spectrum meets a shaping condition is detected, and if the first whitened spectrum meets the shaping condition, the step of shaping the first whitened spectrum to obtain a second whitened spectrum is performed. To be specific, in this embodiment of this application, a shaping detection mechanism can be further introduced to detect whether the first whitened spectrum needs to be shaped. When the first whitened spectrum meets the shaping condition, the first whitened spectrum is shaped. When the first whitened spectrum does not meet the shaping condition, the first whitened spectrum is not shaped, that is, the second whitened spectrum is the first whitened spectrum.

In this embodiment of this application, an implementation of detecting whether the first whitened spectrum meets the shaping condition is as follows: determining first average energy and second average energy based on the first whitened spectrum, and if a difference between the first average energy and the second average energy exceeds a first threshold, determining that the first whitened spectrum meets the shaping condition. The first average energy is an average value of spectral energy of the first whitened spectrum in a first preset frequency band, and the second average energy is an average value of spectral energy of the first whitened spectrum in a second preset frequency band. It should be noted that the difference between the first average energy and the second average energy is an absolute value of a difference between the first average energy and the second average energy.

Optionally, the first preset frequency band may be preset based on one or more factors of a sampling rate, a channel quantity, an encoding rate, encoding bandwidth, and an encoding mode that correspond to the media data. For example, the first preset frequency band is preset to 0 kHz to 4 kHz, and the second preset frequency band is preset to 4 kHz to 8.25 kHz. Certainly, the first preset frequency band may alternatively be a first frequency subband or a second frequency subband described above, and the second preset frequency band may alternatively be a first frequency subband or a second frequency subband different from the first preset frequency band. That is, a manner of setting the first preset frequency band and the second preset frequency band is not limited in this embodiment of this application.

It should be noted that the shaping detection mechanism is optional. For example, when the encoding rate is a specified encoding rate, the first whitened spectrum is directly shaped without shaping detection; or when the encoding rate is not a specified encoding rate, shaping detection is performed, and the first whitened spectrum is shaped when the first whitened spectrum meets the shaping condition. For example, the first whitened spectrum is directly shaped in the case of a low encoding rate, and shaping detection is performed in the case of a high encoding rate. The specified encoding rate may be a preset encoding rate, or any encoding rate within a preset encoding rate range. In addition, if the encoder side determines, by using the shaping detection mechanism, whether the first whitened spectrum is shaped, the encoder side encodes a flag indicating whether shaping is performed into the bitstream.

Step 603: Process the second whitened spectrum by using an encoding neural network model to obtain a first latent variable, where the first latent variable indicates a feature of the second whitened spectrum.

In this embodiment of this application, after the second whitened spectrum is obtained, the second whitened spectrum is processed by using the encoding neural network model to obtain the first latent variable, where the first latent variable indicates the feature of the second whitened spectrum.

It should be noted that, because the spectral amplitude of the second whitened spectrum in the target frequency band is greater than or equal to the spectral amplitude of the first whitened spectrum in the target frequency band, in this solution, a dynamic range of statistical average energy distribution of a whitened spectrum can be reduced, and in a process of extracting whitened spectral features by using the encoding neural network model, more whitened spectral features can be retained, to improve encoding quality. For example, in the case of a medium or low encoding rate, more medium-frequency and high-frequency whitened spectral features can be retained, to improve encoding quality.

Optionally, this embodiment of this application may be applied to a codec including or not including a context model. As shown in FIG. 7, assuming that this embodiment of this application is applied to a codec not including a context model, an implementation of processing the second whitened spectrum by using the encoding neural network model to obtain the first latent variable is as follows: inputting the second whitened spectrum to the encoding neural network model to obtain the first latent variable output by the encoding neural network model. Assuming that this embodiment of this application is applied to a codec including a context model, as shown in FIG. 8, the second whitened spectrum may also be input to the encoding neural network model to obtain the first latent variable output by the encoding neural network model.

The encoding neural network model can be used to extract the feature of the second whitened spectrum. The encoding neural network model is a pre-trained artificial intelligence (AI) model. A network structure and a training method of the encoding neural network model are not limited in this embodiment of this application. For example, the network structure of the encoding neural network model may be a fully connected network or a convolutional neural network (CNN). In addition, a quantity of layers included in the network structure of the encoding neural network model and a quantity of nodes at each layer are not limited in this embodiment of this application either.

Step 604: Encode the first latent variable into a bitstream.

In this embodiment of this application, after the first latent variable is obtained, the first latent variable is encoded into the bitstream. An implementation process of encoding the first latent variable into the bitstream is as follows: performing entropy encoding on the first latent variable to obtain an encoding result of the first latent variable, and writing the encoding result of the first latent variable into the bitstream.

During entropy encoding on the first latent variable, entropy encoding may be performed based on an adjustable entropy encoding model, or entropy encoding may be performed by using an entropy encoding model with a preset probability distribution. This is not limited in this embodiment of this application. Entropy encoding may be one of arithmetic coding, range coding, or Huffman coding. This is not limited in this embodiment of this application.

In some embodiments, in a process of encoding the first latent variable into the bitstream, the first latent variable may be first quantized. As shown in FIG. 7, the first latent variable is quantized to obtain a second latent variable, namely, a quantized first latent variable. Then arithmetic coding is performed on the second latent variable to obtain an encoding result of the second latent variable, and the encoding result of the second latent variable is written into the bitstream.

FIG. 8 is still used as an example. After the second whitened spectrum is processed by using the encoding neural network model to obtain the first latent variable, the first latent variable is quantized to obtain the second latent variable. In addition, the first latent variable is processed by using a context encoding network model to obtain a third latent variable. The third latent variable is quantized to obtain a fourth latent variable (namely, a quantized third latent variable). Entropy encoding is performed on the fourth latent variable based on an entropy encoding model to obtain an encoding result of the fourth latent variable, and the encoding result of the fourth latent variable is written into the bitstream. In addition, entropy decoding is performed on the encoding result of the fourth latent variable to obtain a reconstructed fourth latent variable. The reconstructed fourth latent variable is de-quantized to obtain a reconstructed third latent variable. The reconstructed third latent variable is processed by using a context decoding network model to obtain an entropy encoding model parameter. An entropy encoding model corresponding to the entropy encoding model parameter is selected from entropy encoding models with adjustable parameters. Entropy encoding is performed on the second latent variable based on the selected entropy encoding model to obtain an encoding result of the second latent variable, and the encoding result of the second latent variable is written into the bitstream.

In addition, in this embodiment of this application, a to-be-quantized latent variable may be quantized in a plurality of manners. For example, scalar quantization is performed on each element in the to-be-quantized latent variable. A quantization step of the scalar quantization may be determined based on different encoding rates. To be specific, a correspondence between an encoding rate and a quantization step is prestored, and a corresponding quantization step may be obtained from the correspondence based on an encoding rate used in this embodiment of this application. In addition, the scalar quantization may further have an offset. To be specific, offset processing is performed on the first latent variable based on the offset, and then scalar quantization is performed based on the quantization step.

It should be noted that a quantization manner and an entropy encoding manner below are similar to those herein. For the quantization manner and the entropy encoding manner below, refer to the manners herein. Details are not described below again in this embodiment of this application.

The implementations of encoding the first latent variable into the bitstream in the foregoing descriptions are merely some example implementations provided in this embodiment of this application. In addition to the foregoing implementations, there may alternatively be other implementations of encoding the first latent variable into the bitstream. This is not limited in this embodiment of this application.

It should be noted that, in this embodiment of this application, if the to-be-encoded media data is encoded by using the encoding method shown in FIG. 8, in addition to writing the encoding result of the fourth latent variable and the encoding result of the second latent variable into the bitstream in the foregoing descriptions, the LPC coefficient further needs to be quantized and encoded to obtain an encoding result of the LPC coefficient, and the encoding result of the LPC coefficient is written into the bitstream. The encoding result of the LPC coefficient is used for decoding on a decoder side.

To sum up, in this embodiment of this application, the first whitened spectrum for the media data is whitened to obtain the second whitened spectrum, and then encoding is performed based on the second whitened spectrum. The spectral amplitude of the second whitened spectrum in the target frequency band is greater than or equal to the spectral amplitude of the first whitened spectrum in the target frequency band. It can be learned that, in this solution, the spectral amplitude of the first whitened spectrum in the target frequency band is increased, so that a difference between statistical average energy of spectral lines for different frequencies in the obtained second whitened spectrum is small. In this way, in a process of processing the second whitened spectrum by using the encoding neural network model, more spectral lines in the second whitened spectrum can be retained. To be specific, in this solution, more spectral lines can be encoded, so that more spectral features are retained, and encoding quality is improved.

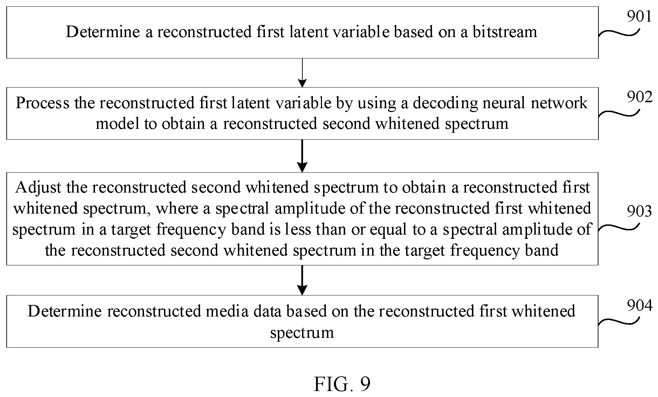

FIG. 9 is a flowchart of a decoding method according to an embodiment of this application. The method is applied to a decoder side. The method corresponds to the encoding method shown in FIG. 6. The decoding method includes the following steps.

Step 901: Determine a reconstructed first latent variable based on a bitstream.

In this embodiment of this application, an implementation of determining the reconstructed first latent variable based on the bitstream is as follows: performing entropy decoding on an encoding result of a first latent variable in the bitstream to obtain the reconstructed first latent variable. During entropy decoding on the encoding result of the first latent variable, entropy decoding may be performed based on an adjustable entropy decoding model, or entropy decoding may be performed by using an entropy decoding model with a preset probability distribution. This is not limited in this embodiment of this application. It should be noted that an entropy decoding manner below is similar to that herein. For the entropy decoding manner below, refer to the manner herein. Details are not described below again in this embodiment of this application.

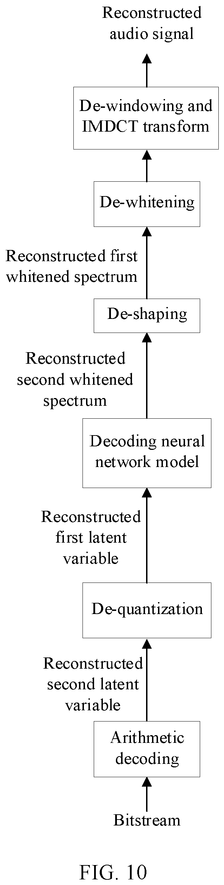

FIG. 10 is a block diagram of an example decoding method according to an embodiment of this application. The decoding method shown in FIG. 10 corresponds to the encoding method shown in FIG. 7. As shown in FIG. 10, an implementation process of determining the reconstructed first latent variable based on the bitstream is as follows: performing arithmetic decoding on an encoding result of a second latent variable in the bitstream to obtain a reconstructed second latent variable; and de-quantizing the reconstructed second latent variable to obtain the reconstructed first latent variable.

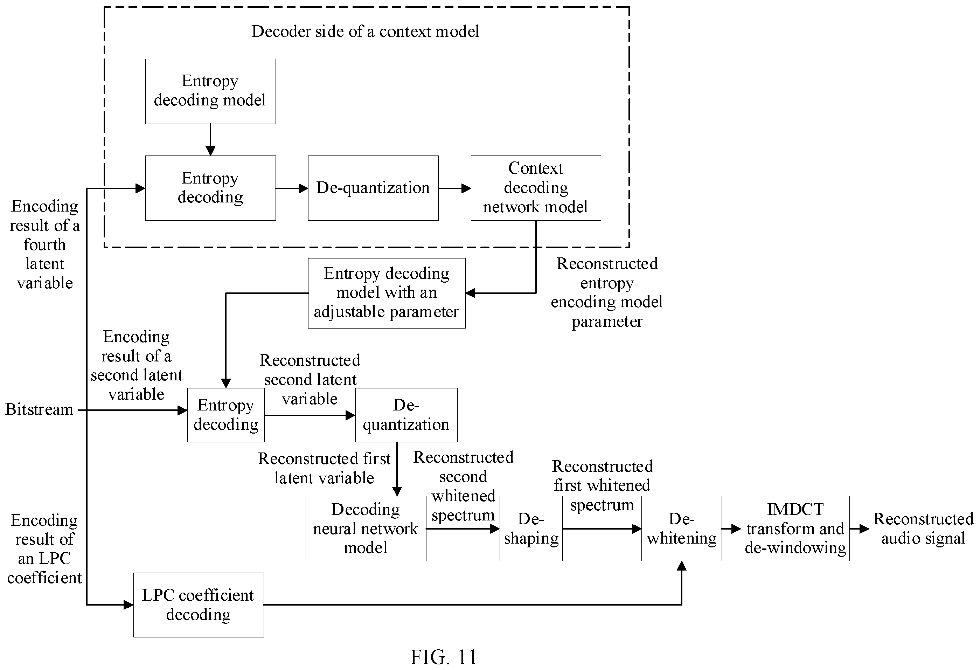

FIG. 11 is a block diagram of another example decoding method according to an embodiment of this application. The decoding method shown in FIG. 11 corresponds to the encoding method shown in FIG. 8. As shown in FIG. 11, a bitstream includes an encoding result of a second latent variable and an encoding result of a fourth latent variable. An implementation process of determining the reconstructed first latent variable based on the bitstream is as follows: first, performing entropy decoding on the encoding result of the fourth latent variable by using an entropy decoding model with a fixed parameter, to obtain a reconstructed fourth latent variable; de-quantizing the reconstructed fourth latent variable to obtain a reconstructed third latent variable; processing the reconstructed third latent variable by using a context decoding network model to obtain a reconstructed entropy encoding model parameter; selecting a corresponding entropy decoding model from entropy decoding models with adjustable parameters based on the reconstructed entropy encoding model parameter: performing entropy decoding on the encoding result of the second latent variable in the bitstream based on the selected entropy decoding model to obtain a reconstructed second latent variable; and de-quantizing the reconstructed second latent variable to obtain the reconstructed first latent variable.

The decoding method in this step corresponds to an encoding method on an encoder side, and the de-quantization in this step corresponds to quantization on the encoder side. To be specific, the decoding method is an inverse process of the encoding method, and the de-quantization is an inverse process of the quantization.

Step 902: Process the reconstructed first latent variable by using a decoding neural network model to obtain a reconstructed second whitened spectrum.

In this embodiment of this application, an implementation of processing the reconstructed first latent variable by using the decoding neural network model to obtain the reconstructed second whitened spectrum is as follows: inputting the reconstructed first latent variable to the decoding neural network model to obtain the reconstructed second whitened spectrum output by the decoding neural network model.

The decoding neural network model corresponds to an encoding neural network model, and both are pre-trained. A network structure and a training method of the decoding neural network model are not limited in this embodiment of this application. For example, the network structure of the decoding neural network model may be a fully connected network or a CNN network. In addition, a quantity of layers included in the network structure of the decoding neural network model and a quantity of nodes at each layer are not limited in this embodiment of this application either.

As shown in FIG. 10, an implementation process of processing the reconstructed first latent variable by using the decoding neural network model to obtain the reconstructed second whitened spectrum is as follows: inputting the reconstructed first latent variable to the decoding neural network model to obtain the reconstructed second whitened spectrum output by the decoding neural network model.

The decoding method shown in FIG. 11 is still used as an example. An implementation process of processing the reconstructed first latent variable by using the decoding neural network model to obtain the reconstructed second whitened spectrum is also as follows: inputting the reconstructed first latent variable to the decoding neural network model to obtain the reconstructed second whitened spectrum output by the decoding neural network model.

It should be noted that this step is an inverse process of processing a second whitened spectrum by using the encoding neural network model to obtain a first latent variable on the encoder side.

Step 903: Adjust the reconstructed second whitened spectrum to obtain a reconstructed first whitened spectrum, where a spectral amplitude of the reconstructed first whitened spectrum in a target frequency band is less than or equal to a spectral amplitude of the reconstructed second whitened spectrum in the target frequency band.

Because the second whitened spectrum is obtained by shaping a first whitened spectrum, the reconstructed second whitened spectrum may be adjusted to obtain the reconstructed first whitened spectrum. A process of adjusting the reconstructed second whitened spectrum is an inverse process of shaping the first whitened spectrum on the encoder side. For example, an implementation of adjusting the reconstructed second whitened spectrum to obtain the reconstructed first whitened spectrum is as follows: adjusting the reconstructed second whitened spectrum based on a gain adjustment factor to obtain the reconstructed first whitened spectrum. The spectral amplitude of the reconstructed first whitened spectrum in the target frequency band is less than or equal to the spectral amplitude of the reconstructed second whitened spectrum in the target frequency band.

Optionally, the target frequency band is determined based on one or more factors of a sampling rate, a channel quantity, an encoding rate, encoding bandwidth, and an encoding mode that correspond to to-be-decoded media data. The target frequency band covers an entire range or a partial range of a spectral range of the media data. It should be noted that, in this embodiment of this application, the target frequency band during decoding is the same as a target frequency band during encoding. To be specific, a frequency band in which the reconstructed second whitened spectrum needs to be adjusted is also the target frequency band. If the target frequency band is determined based on the first whitened spectrum, the encoder side encodes information indicating the target frequency band into a bitstream, and the decoder side parses the information in the bitstream to determine the target frequency band.

In this embodiment of this application, the target frequency band includes a second quantity of second frequency subbands, and the gain adjustment factor includes an adjustment factor corresponding to each of the second quantity of second frequency subbands. Based on this, an implementation process of adjusting the reconstructed second whitened spectrum based on the gain adjustment factor to obtain the reconstructed first whitened spectrum is as follows: determining a spectral value of the reconstructed second whitened spectrum at a frequency in each of the second quantity or a plurality of second frequency subbands; and adjusting the spectral value of the reconstructed second whitened spectrum at the frequency in each of the second quantity of second frequency subbands based on an adjustment factor corresponding to each of the second quantity of second frequency subbands, to obtain the reconstructed first whitened spectrum.

The gain adjustment factor in this step is also the same as a gain adjustment factor during encoding. A process of adjusting the reconstructed second whitened spectrum based on the adjustment factor corresponding to each second frequency subband is an inverse process of shaping the first whitened spectrum based on an adjustment factor corresponding to each second frequency subband in the encoding method. For example, a first to-be-adjusted frequency subband is any one of the second quantity of second frequency subbands. For the first to-be-adjusted frequency subband, if the encoder side multiplies a spectral value of the first whitened spectrum at a frequency in the first to-be-adjusted frequency subband by a corresponding adjustment factor, the decoder side divides a spectral value of the reconstructed second whitened spectrum at the frequency in the first to-be-adjusted frequency subband by the corresponding adjustment factor; or if the encoder side divides a spectral value of the first whitened spectrum at a frequency in the first to-be-adjusted frequency subband by a corresponding adjustment factor, the decoder side multiplies a spectral value of the reconstructed second whitened spectrum at the frequency in the first to-be-adjusted frequency subband by the corresponding adjustment factor.

In this embodiment of this application, corresponding to a case on the encoder side, adjustment factors corresponding to all of the second quantity of second frequency subbands may be determined in a same manner or different manners, and the adjustment factor corresponding to the first to-be-adjusted frequency subband of the second quantity of second frequency subbands meets the following condition: frequencies in the first to-be-adjusted frequency subband correspond to one adjustment factor, and the adjustment factor is a preset value; or frequencies in the first to-be-adjusted frequency subband correspond to different adjustment factors, and adjustment factors corresponding to at least a part of the frequencies are determined through linear interpolation; or adjustment factors corresponding to frequencies in the first to-be-adjusted frequency subband are different, and the adjustment factors corresponding to the frequencies are determined according to a preset function.

It should be noted that, in this embodiment of this application, a manner of determining the adjustment factor corresponding to each of the second quantity of second frequency subbands on the decoder side is the same as that on the encoder side, and determined adjustment factors are also the same. To be specific, an adjustment factor corresponding to the first to-be-adjusted frequency subband on the encoder side is the same as an adjustment factor corresponding to the first to-be-adjusted frequency subband on the decoder side.

If frequencies in the first to-be-adjusted frequency subband correspond to one adjustment factor, and the adjustment factor is a preset value, a value may be preset as the adjustment factor corresponding to the frequencies in the first to-be-adjusted frequency subband.

If adjustment factors corresponding to at least a part of the frequencies in the first to-be-adjusted frequency subband are determined through linear interpolation, the adjustment factors corresponding to the at least a part of the frequencies are determined in the following manner: determining a start adjustment factor corresponding to the first to-be-adjusted frequency subband; determining a stop adjustment factor corresponding to the first to-be-adjusted frequency subband; and then determining, based on the start adjustment factor and the stop adjustment factor through linear interpolation, the adjustment factors corresponding to the at least a part of the frequencies.

A solution for determining an adjustment factor through linear interpolation on the decoder side is consistent with that on the encoder side. The at least a part of the frequencies may alternatively not include a start frequency or a stop frequency of the first to-be-adjusted frequency subband, an adjustment factor corresponding to the start frequency is the start adjustment factor, and an adjustment factor corresponding to the stop frequency is the stop adjustment factor. Both the start adjustment factor and the stop adjustment factor are preset values; or the start adjustment factor is a preset value, and the stop adjustment factor is a non-preset value; or the start adjustment factor is a non-preset value, and the stop adjustment factor is a preset value; or both the start adjustment factor and the stop adjustment factor are non-preset values. Based on this, there may also be three solutions for determining adjustment factors corresponding to frequencies in the first to-be-adjusted frequency subband through linear interpolation on the decoder side.

First solution of linear interpolation: Both the start adjustment factor and the stop adjustment factor are preset values.

To be specific, the start adjustment factor and the stop adjustment factor that correspond to the first to-be-adjusted frequency subband are preset. Optionally, it is determined that the start adjustment factor is the adjustment factor corresponding to the start frequency of the first to-be-adjusted frequency subband, and it is determined that the stop adjustment factor is the adjustment factor corresponding to the stop frequency of the first to-be-adjusted frequency subband. Adjustment factors corresponding to frequencies in the first to-be-adjusted frequency subband other than the start frequency and the stop frequency are determined through linear interpolation based on the adjustment factor corresponding to the start frequency of the first to-be-adjusted frequency subband and the adjustment factor corresponding to the stop frequency of the first to-be-adjusted frequency subband. Alternatively, the start adjustment factor and the stop adjustment factor that correspond to the first to-be-adjusted frequency subband are preset, and adjustment factors corresponding to frequencies in the first to-be-adjusted frequency subband are determined based on the start adjustment factor and the stop adjustment factor through linear interpolation. For a specific implementation, refer to related descriptions in the encoding method. Details are not described herein again.

Second solution of linear interpolation: The stop adjustment factor is a non-preset value.

If the stop adjustment factor is a non-preset value, the stop adjustment factor may be an adjustment factor corresponding to a start frequency of a second to-be-adjusted frequency subband, the second to-be-adjusted frequency subband is a second frequency subband located after the first to-be-adjusted frequency subband in the second quantity of second frequency subbands, and the first to-be-adjusted frequency subband and the second to-be-adjusted frequency subband are continuous. In this embodiment of this application, an implementation of determining the stop adjustment factor is as follows: obtaining an adjustment factor corresponding to a start frequency of a second to-be-adjusted frequency subband as the stop adjustment factor.

In the second solution, the start adjustment factor corresponding to the first to-be-adjusted frequency subband may be preset, and then the adjustment factor corresponding to the start frequency of the second to-be-adjusted frequency subband is obtained as the stop adjustment factor. It is determined that the start adjustment factor is the adjustment factor corresponding to the start frequency of the first to-be-adjusted frequency subband, and it is determined that the stop adjustment factor is the adjustment factor corresponding to the stop frequency of the first to-be-adjusted frequency subband. Then adjustment factors corresponding to frequencies in the first to-be-adjusted frequency subband other than the start frequency and the stop frequency are determined through linear interpolation based on the adjustment factor corresponding to the start frequency of the first to-be-adjusted frequency subband and the adjustment factor corresponding to the stop frequency.

Alternatively, after the adjustment factor corresponding to the start frequency of the second to-be-adjusted frequency subband is obtained as the stop adjustment factor, adjustment factors corresponding to frequencies in the first to-be-adjusted frequency subband other than the start frequency are determined through linear interpolation based on the adjustment factor corresponding to the start frequency of the first to-be-adjusted frequency subband and the stop adjustment factor.

Optionally, the adjustment factor corresponding to the start frequency of the second to-be-adjusted frequency subband may be preset, determined through linear interpolation, or determined according to a preset function. This is not limited in this embodiment of this application.

Third solution of linear interpolation: The start adjustment factor is a non-preset value.

If the start adjustment factor is a non-preset value, the start adjustment factor may be an adjustment factor corresponding to a stop frequency of a third to-be-adjusted frequency subband, the third to-be-adjusted frequency subband is a second frequency subband located before the first to-be-adjusted frequency subband in the second quantity of second frequency subbands, and the first to-be-adjusted frequency subband and the third to-be-adjusted frequency subband are continuous. In this embodiment of this application, an implementation of determining the start adjustment factor is as follows: obtaining an adjustment factor corresponding to a stop frequency of a third to-be-adjusted frequency subband as the start adjustment factor.

In the second solution, the stop adjustment factor corresponding to the first to-be-adjusted frequency subband may be preset, and then the adjustment factor corresponding to the stop frequency of the third to-be-adjusted frequency subband is obtained as the start adjustment factor. It is determined that the start adjustment factor is the adjustment factor corresponding to the start frequency of the first to-be-adjusted frequency subband, and it is determined that the stop adjustment factor is the adjustment factor corresponding to the stop frequency of the first to-be-adjusted frequency subband. Adjustment factors corresponding to frequencies in the first to-be-adjusted frequency subband other than the start frequency and the stop frequency are determined through linear interpolation based on the adjustment factor corresponding to the start frequency of the first to-be-adjusted frequency subband and the adjustment factor corresponding to the stop frequency of the first to-be-adjusted frequency subband.

Alternatively, after the adjustment factor corresponding to the stop frequency of the third to-be-adjusted frequency subband is obtained as the start adjustment factor, adjustment factors corresponding to frequencies in the first to-be-adjusted frequency subband other than the stop frequency are determined through linear interpolation based on the start adjustment factor and the adjustment factor corresponding to the stop frequency of the first to-be-adjusted frequency subband.

Optionally, the adjustment factor corresponding to the stop frequency of the third to-be-adjusted frequency subband may be preset, determined through linear interpolation, or determined according to a preset function. This is not limited in this embodiment of this application.

It should be noted that, for specific implementations of the three solutions of linear interpolation on the decoder side, reference may be made to detailed descriptions of related content in step 602 in the embodiment shown in FIG. 6. Details are not described herein again.

If the adjustment factors corresponding to the frequencies in the first to-be-adjusted frequency subband are determined according to the preset function, before the first whitened spectrum is shaped based on the gain adjustment factor to obtain the second whitened spectrum, a preset function corresponding to the first to-be-adjusted frequency subband is obtained from one or more stored preset functions, a function argument range corresponding to the first to-be-adjusted frequency subband is obtained, and the adjustment factors corresponding to the frequencies in the first to-be-adjusted frequency subband are determined according to the preset function corresponding to the first to-be-adjusted frequency subband and based on the function argument range corresponding to the first to-be-adjusted frequency subband. For a specific implementation process, refer to related descriptions of step 602 in the embodiment of FIG. 6. Details are not described herein again.

In this embodiment of this application, after the adjustment factor corresponding to each of the second quantity of second frequency subbands is determined, a spectral value of the reconstructed second whitened spectrum at each frequency in a corresponding frequency band is adjusted based on the adjustment factor corresponding to each second frequency subband, to obtain the reconstructed first whitened spectrum. For example, in the two decoding methods shown in FIG. 10 and FIG. 11, the reconstructed second whitened spectrum is adjusted, namely, de-shaped, based on the gain adjustment factor to obtain the reconstructed first whitened spectrum.

It should be noted that, if the encoder side does not shape the first whitened spectrum, for example, the encoder side determines, by using a shaping detection mechanism, that the first whitened spectrum does not need to be shaped this time, the encoder side encodes a flag indicating whether shaping is performed into the bitstream. In this case, the decoder side determines, by parsing the flag in the bitstream, whether the encoder side performs shaping. If shaping does not need to be performed, the decoder side does not need to adjust the reconstructed second whitened spectrum either, and the decoder side directly uses the reconstructed second whitened spectrum as the reconstructed first whitened spectrum.

Step 904: Determine reconstructed media data based on the reconstructed first whitened spectrum.

In this embodiment of this application, an implementation of determining the reconstructed media data based on the reconstructed first whitened spectrum may be as follows: de-whitening the reconstructed first whitened spectrum to obtain the reconstructed media data.

Optionally, if the to-be-decoded media data is frequency-domain media data, the reconstructed first whitened spectrum is de-whitened to obtain reconstructed frequency-domain media data, namely, the reconstructed media data. If the to-be-decoded media data is time-domain media data, after reconstructed frequency-domain media data is obtained, inverse transformation of time-domain transformation is performed on the reconstructed frequency-domain media data to obtain reconstructed time-domain media data, namely, the reconstructed media data. Alternatively, after obtaining the reconstructed time-domain media data, the decoder side performs post-processing on the reconstructed time-domain media data to obtain the reconstructed media data.

To be specific, this step is an inverse process of determining a first whitened spectrum for to-be-encoded media data on the encoder side.

An audio signal in FIG. 10 is used as an example. The decoder side de-whitens reconstructed first media data to obtain a reconstructed frequency-domain signal. Inverse modified discrete cosine transform (IMDCT) and de-windowing are performed on the reconstructed frequency-domain signal to obtain a reconstructed audio signal.

An audio signal in FIG. 11 is used as an example. The decoder side decodes an encoding result of an LPC coefficient in a bitstream to obtain a reconstructed LPC coefficient. The reconstructed first whitened spectrum is de-whitened based on the reconstructed LPC coefficient to obtain reconstructed frequency-domain media data. IMDCT transform and de-windowing are performed on the reconstructed frequency-domain media data to obtain reconstructed media data. That is, a reconstructed audio signal is obtained through decoding.

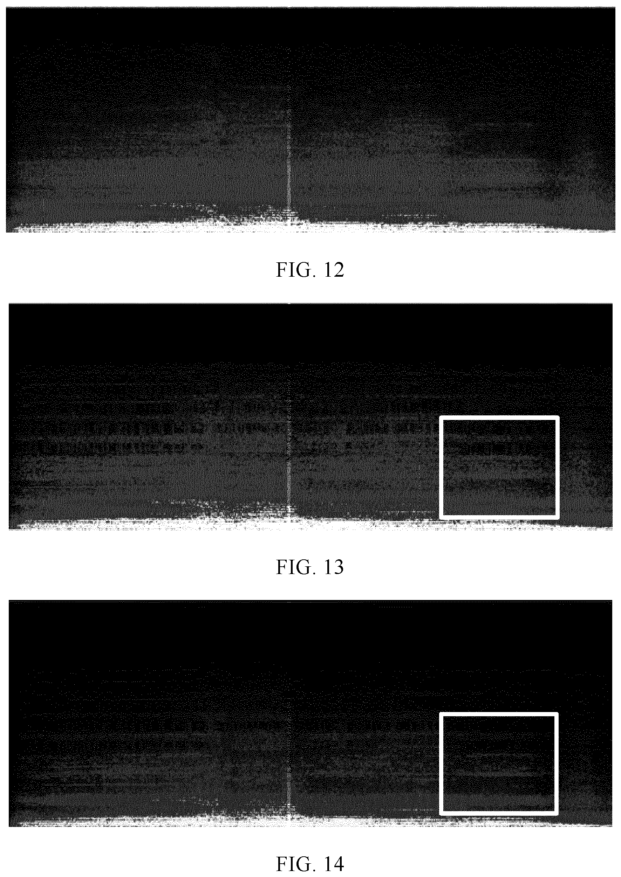

FIG. 12 is a diagram of spectral lines for a raw signal according to an embodiment of this application. FIG. 13 is a diagram of spectral lines obtained by encoding and decoding the raw signal in this solution (namely, a diagram of spectral lines of a reconstructed signal, also referred to as a compensated coded signal). FIG. 14 is a diagram of spectral lines obtained by decoding the raw signal without processing in this solution (a decoded signal is also referred to as an uncompensated coded signal). It can be learned that, compared with FIG. 14, more spectral lines of the raw signal are retained in the coded signal shown in FIG. 13. For example, a quantity of spectral lines in a rectangular box in FIG. 13 is obviously greater than that of spectral lines in a rectangular box at a same location in FIG. 14. That is, a similarity between FIG. 13 and FIG. 12 is higher, and encoding quality is improved in this solution.

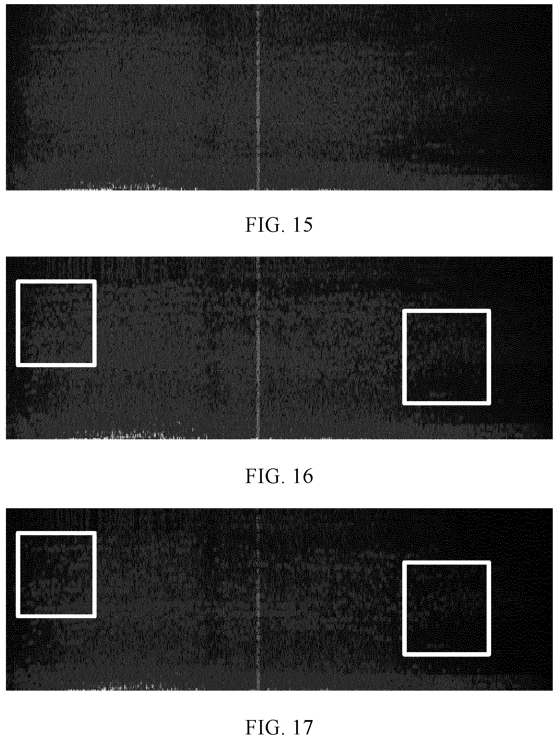

FIG. 15 is a diagram of spectral lines for a raw signal according to an embodiment of this application. FIG. 16 is a diagram of spectral lines obtained by encoding and decoding the raw signal in this solution. FIG. 17 is a diagram of spectral lines obtained by decoding the raw signal without processing in this solution. It can be learned that, compared with FIG. 17, more spectral lines of the raw signal are retained in a coded signal shown in FIG. 16. For example, a quantity of spectral lines in two rectangular boxes in FIG. 16 is obviously greater than that of spectral lines in two rectangular boxes at same locations in FIG. 17. A similarity between FIG. 16 and FIG. 15 is higher, and encoding quality is improved in this solution.

It should be noted that the diagrams of spectral lines shown in FIG. 12 to FIG. 17 may have low definition due to document printing or scanning. Consequently, in some cases, that FIG. 13 and FIG. 16 include more spectral lines may not be obviously learned from accompanying drawings of the document. However, in this solution, a whitened spectrum is essentially shaped, so that more spectral line features are retained during encoding, and media data with higher quality is restored during decoding, to be specific, the restored media data includes more spectral lines. Therefore, regardless of whether the diagrams of spectral lines shown in FIG. 12 to FIG. 17 are provided in this embodiment of this application, the foregoing technical effect can still be learned through analysis based on the technical solution in this embodiment of this application.

To sum up, in this embodiment of this application, the first whitened spectrum for the media data is whitened to obtain the second whitened spectrum, and then encoding is performed based on the second whitened spectrum. The spectral amplitude of the second whitened spectrum in the target frequency band is greater than or equal to the spectral amplitude of the first whitened spectrum in the target frequency band. It can be learned that, in this solution, the spectral amplitude of the first whitened spectrum in the target frequency band is increased, so that a difference between statistical average energy of spectral lines for different frequencies in the obtained second whitened spectrum is small. In this way, in a process of processing the second whitened spectrum by using the encoding neural network model, more spectral lines in the second whitened spectrum can be retained. To be specific, in this solution, more spectral lines can be encoded, so that more spectral features are retained, and encoding quality is improved. Correspondingly, media data obtained on the decoder side through decoding in an inverse process of a corresponding encoding method has a higher degree of restoration, in other words, the media data obtained through decoding has higher quality.

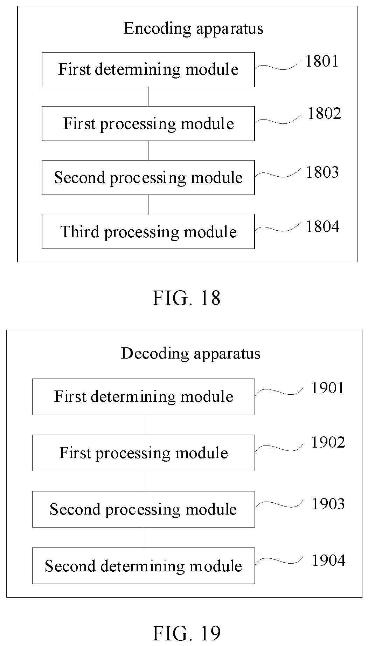

FIG. 18 is a schematic diagram of a structure of an encoding apparatus according to an embodiment of this application. The encoding apparatus may be implemented as a part or an entirety of an encoder-side device by using software, hardware, or a combination thereof. The encoder-side device may be the source apparatus shown in FIG. 1. As shown in FIG. 18, the apparatus includes a first determining module 1801, a first processing module 1802, a second processing module 1803, and a third processing module 1804.

The first determining module 1801 is configured to determine a first whitened spectrum for to-be-encoded media data.

The first processing module 1802 is configured to shape the first whitened spectrum to obtain a second whitened spectrum, where a spectral amplitude of the second whitened spectrum in a target frequency band is greater than or equal to a spectral amplitude of the first whitened spectrum in the target frequency band.

The second processing module 1803 is configured to process the second whitened spectrum by using an encoding neural network model to obtain a first latent variable, where the first latent variable indicates a feature of the second whitened spectrum.

The third processing module 1804 is configured to encode the first latent variable into a bitstream.

Optionally, the target frequency band is preset, or the target frequency band is determined based on the first whitened spectrum.

Optionally, if the target frequency band is determined based on the first whitened spectrum, the apparatus further includes:
a division module, configured to divide a spectral range of the media data into a first quantity of first frequency subbands;
a second determining module, configured to determine an average value of spectral energy of the first whitened spectrum in each of the first quantity of first frequency subbands to obtain a first quantity of average values of spectral energy of frequency subbands;
a third determining module, configured to determine an average value of spectral energy of the first whitened spectrum within the spectral range; and
a fourth determining module, configured to determine, based on the average value of spectral energy and the first quantity of average values of spectral energy of frequency subbands, a first frequency subband included in the target frequency band.

Optionally, the fourth determining module includes:
a first processing submodule, configured to use a first frequency subband corresponding to an average value of spectral energy, in the first quantity of average values of spectral energy of frequency subbands, whose difference from the average value of spectral energy exceeds a specified threshold as the first frequency subband included in the target frequency band.

Optionally, the first processing module 1802 includes:
a second processing submodule, configured to shape the first whitened spectrum based on a gain adjustment factor to obtain the second whitened spectrum.

Optionally, the target frequency band includes a second quantity of second frequency subbands, and the gain adjustment factor includes an adjustment factor corresponding to each of the second quantity of second frequency subbands.

The second processing submodule is specifically configured to:
determine a spectral value of the first whitened spectrum at a frequency in each of the second quantity of second frequency subbands; and
adjust the spectral value of the first whitened spectrum at the frequency in each of the second quantity of second frequency subbands based on an adjustment factor corresponding to each of the second quantity of second frequency subbands, to obtain the second whitened spectrum.

Optionally, adjustment factors corresponding to all of the second quantity of second frequency subbands may be determined in a same manner or different manners, and an adjustment factor corresponding to a first to-be-adjusted frequency subband of the second quantity of second frequency subbands meets the following condition:
frequencies in the first to-be-adjusted frequency subband correspond to one adjustment factor, and the adjustment factor is a preset value; or
frequencies in the first to-be-adjusted frequency subband correspond to different adjustment factors, and adjustment factors corresponding to at least a part of the frequencies are determined through linear interpolation; or
adjustment factors corresponding to frequencies in the first to-be-adjusted frequency subband are different, and the adjustment factors corresponding to the frequencies are determined according to a preset function.

Optionally, the adjustment factors corresponding to the at least a part of the frequencies are determined in the following manner:
determining a start adjustment factor corresponding to the first to-be-adjusted frequency subband;
determining a stop adjustment factor corresponding to the first to-be-adjusted frequency subband; and
determining, based on the start adjustment factor and the stop adjustment factor through linear interpolation, the adjustment factors corresponding to the at least a part of the frequencies.

Optionally, the at least a part of the frequencies do not include a start frequency or a stop frequency of the first to-be-adjusted frequency subband; and
an adjustment factor corresponding to the start frequency is the start adjustment factor, and an adjustment factor corresponding to the stop frequency is the stop adjustment factor.

Optionally, both the start adjustment factor and the stop adjustment factor are preset values; or
the start adjustment factor is a preset value and the stop adjustment factor is a non-preset value; or
the start adjustment factor is a non-preset value and the stop adjustment factor is a preset value; or
both the start adjustment factor and the stop adjustment factor are non-preset values.

Optionally, when the stop adjustment factor is a non-preset value, the stop adjustment factor is an adjustment factor corresponding to a start frequency of a second to-be-adjusted frequency subband, the second to-be-adjusted frequency subband is a second frequency subband located after the first to-be-adjusted frequency subband in the second quantity of second frequency subbands, and the first to-be-adjusted frequency subband and the second to-be-adjusted frequency subband are continuous.

Optionally, when the start adjustment factor is a non-preset value, the start adjustment factor is an adjustment factor corresponding to a stop frequency of a third to-be-adjusted frequency subband, the third to-be-adjusted frequency subband is a second frequency subband located before the first to-be-adjusted frequency subband in the second quantity of second frequency subbands, and the first to-be-adjusted frequency subband and the third to-be-adjusted frequency subband are continuous.

Optionally, if the adjustment factors corresponding to the frequencies in the first to-be-adjusted frequency subband are determined according to the preset function, the first processing module 1802 further includes:
an obtaining submodule, configured to obtain, from one or more stored preset functions, a preset function corresponding to the first to-be-adjusted frequency subband, and obtain a function argument range corresponding to the first to-be-adjusted frequency subband; and
a determining submodule, configured to determine the adjustment factors corresponding to the frequencies in the first to-be-adjusted frequency subband according to the preset function corresponding to the first to-be-adjusted frequency subband and based on the function argument range corresponding to the first to-be-adjusted frequency subband.

Optionally, the target frequency band is determined based on one or more factors of a sampling rate, a channel quantity, an encoding rate, encoding bandwidth, and an encoding mode that correspond to the media data.

Optionally, the target frequency band covers an entire range or a partial range of the spectral range of the media data.

Optionally, the apparatus further includes:
a detection module, configured to detect whether the first whitened spectrum meets a shaping condition; and
a trigger module, configured to: if the first whitened spectrum meets the shaping condition, trigger the first processing module 1802 to perform the step of shaping the first whitened spectrum to obtain a second whitened spectrum.

Optionally, the detection module includes:
a fifth determining module, configured to determine first average energy and second average energy based on the first whitened spectrum, where the first average energy is an average value of spectral energy of the first whitened spectrum in a first preset frequency band, and the second average energy is an average value of spectral energy of the first whitened spectrum in a second preset frequency band; and
a sixth determining module, configured to: if a difference between the first average energy and the second average energy exceeds a first threshold, determine that the first whitened spectrum meets the shaping condition.

In this embodiment of this application, the first whitened spectrum for the media data is whitened to obtain the second whitened spectrum, and then encoding is performed based on the second whitened spectrum. The spectral amplitude of the second whitened spectrum in the target frequency band is greater than or equal to the spectral amplitude of the first whitened spectrum in the target frequency band. It can be learned that, in this solution, the spectral amplitude of the first whitened spectrum in the target frequency band is increased, so that a difference between statistical average energy of spectral lines for different frequencies in the obtained second whitened spectrum is small. In this way, in a process of processing the second whitened spectrum by using the encoding neural network model, more spectral lines in the second whitened spectrum can be retained. To be specific, in this solution, more spectral lines can be encoded, so that more spectral features are retained, and encoding quality is improved.

It should be noted that, during encoding by the encoding apparatus provided in the foregoing embodiment, division into the foregoing functional modules is merely used as an example for description. In actual application, the foregoing functions may be allocated to different functional modules and implemented according to a requirement. To be specific, an internal structure of the apparatus is divided into different functional modules to implement all or some of the functions described above. In addition, the encoding apparatus provided in the foregoing embodiment and the encoding method embodiment belong to a same concept. For details about a specific implementation process of the encoding apparatus, refer to the method embodiment. Details are not described herein again.

FIG. 19 is a schematic diagram of a structure of a decoding apparatus according to an embodiment of this application. The decoding apparatus may be implemented as a part or an entirety of a decoder-side device by using software, hardware, or a combination thereof. The decoder-side device may be the destination apparatus shown in FIG. 1. As shown in FIG. 19, the apparatus includes a first determining module 1901, a first processing module 1902, a second processing module 1903, and a second determining module 1904.

The first determining module 1901 is configured to determine a reconstructed first latent variable based on a bitstream.

The first processing module 1902 is configured to process the reconstructed first latent variable by using a decoding neural network model to obtain a reconstructed second whitened spectrum.

The second processing module 1903 is configured to adjust the reconstructed second whitened spectrum to obtain a reconstructed first whitened spectrum, where a spectral amplitude of the reconstructed first whitened spectrum in a target frequency band is less than or equal to a spectral amplitude of the reconstructed second whitened spectrum in the target frequency band.

The second determining module 1904 is configured to determine reconstructed media data based on the reconstructed first whitened spectrum.

Optionally, the second processing module 1903 includes:
a processing submodule, configured to adjust the reconstructed second whitened spectrum based on a gain adjustment factor to obtain the reconstructed first whitened spectrum.

Optionally, the target frequency band includes a second quantity of second frequency subbands, and the gain adjustment factor includes an adjustment factor corresponding to each of the second quantity of second frequency subbands.

The processing submodule is specifically configured to:
determine a spectral value of the reconstructed second whitened spectrum at a frequency in each of the second quantity of second frequency subbands; and
adjust the spectral value of the reconstructed second whitened spectrum at the frequency in each of the second quantity of second frequency subbands based on an adjustment factor corresponding to each of the second quantity of second frequency subbands, to obtain the reconstructed first whitened spectrum.

Optionally, adjustment factors corresponding to all of the second quantity of second frequency subbands may be determined in a same manner or different manners, and an adjustment factor corresponding to a first to-be-adjusted frequency subband of the second quantity of second frequency subbands meets the following condition:
frequencies in the first to-be-adjusted frequency subband correspond to one adjustment factor, and the adjustment factor is a preset value; or
frequencies in the first to-be-adjusted frequency subband correspond to different adjustment factors, and adjustment factors corresponding to at least a part of the frequencies are determined through linear interpolation; or
adjustment factors corresponding to frequencies in the first to-be-adjusted frequency subband are different, and the adjustment factors corresponding to the frequencies are determined according to a preset function.

Optionally, the adjustment factors corresponding to the at least a part of the frequencies are determined in the following manner:
determining a start adjustment factor corresponding to the first to-be-adjusted frequency subband;
determining a stop adjustment factor corresponding to the first to-be-adjusted frequency subband; and
determining, based on the start adjustment factor and the stop adjustment factor through linear interpolation, the adjustment factors corresponding to the at least a part of the frequencies.

Optionally, the at least a part of the frequencies do not include a start frequency or a stop frequency of the first to-be-adjusted frequency subband; and
an adjustment factor corresponding to the start frequency is the start adjustment factor, and an adjustment factor corresponding to the stop frequency is the stop adjustment factor.

Optionally, both the start adjustment factor and the stop adjustment factor are preset values; or
the start adjustment factor is a preset value and the stop adjustment factor is a non-preset value; or
the start adjustment factor is a non-preset value and the stop adjustment factor is a preset value; or
both the start adjustment factor and the stop adjustment factor are non-preset values.

Optionally, when the stop adjustment factor is a non-preset value, the stop adjustment factor is an adjustment factor corresponding to a start frequency of a second to-be-adjusted frequency subband, the second to-be-adjusted frequency subband is a second frequency subband located after the first to-be-adjusted frequency subband in the second quantity of second frequency subbands, and the first to-be-adjusted frequency subband and the second to-be-adjusted frequency subband are continuous.

Optionally, when the start adjustment factor is a non-preset value, the start adjustment factor is an adjustment factor corresponding to a stop frequency of a third to-be-adjusted frequency subband, the third to-be-adjusted frequency subband is a second frequency subband located before the first to-be-adjusted frequency subband in the second quantity of second frequency subbands, and the first to-be-adjusted frequency subband and the third to-be-adjusted frequency subband are continuous.

Optionally, if the adjustment factors corresponding to the frequencies in the first to-be-adjusted frequency subband are determined according to the preset function, the second processing module 1903 further includes:
an obtaining submodule, configured to obtain, from one or more stored preset functions, a preset function corresponding to the first to-be-adjusted frequency subband, and obtain a function argument range corresponding to the first to-be-adjusted frequency subband; and
a determining submodule, configured to determine the adjustment factors corresponding to the frequencies in the first to-be-adjusted frequency subband according to the preset function corresponding to the first to-be-adjusted frequency subband and based on the function argument range corresponding to the first to-be-adjusted frequency subband.

Optionally, the target frequency band is determined based on one or more factors of a sampling rate, a channel quantity, an encoding rate, encoding bandwidth, and an encoding mode that correspond to the media data.

Optionally, the target frequency band covers an entire range or a partial range of the spectral range of the media data.

In this embodiment of this application, the first whitened spectrum for the media data is whitened to obtain the second whitened spectrum, and then encoding is performed based on the second whitened spectrum. The spectral amplitude of the second whitened spectrum in the target frequency band is greater than or equal to the spectral amplitude of the first whitened spectrum in the target frequency band. It can be learned that, in this solution, the spectral amplitude of the first whitened spectrum in the target frequency band is increased, so that a difference between statistical average energy of spectral lines for different frequencies in the obtained second whitened spectrum is small. In this way, in a process of processing the second whitened spectrum by using the encoding neural network model, more spectral lines in the second whitened spectrum can be retained. To be specific, in this solution, more spectral lines can be encoded, so that more spectral features are retained, and encoding quality is improved.

It should be noted that, during decoding by the decoding apparatus provided in the foregoing embodiment, division into the foregoing functional modules is merely used as an example for description. In actual application, the foregoing functions may be allocated to different functional modules and implemented according to a requirement. To be specific, an internal structure of the apparatus is divided into different functional modules to implement all or some of the functions described above. In addition, the decoding apparatus provided in the foregoing embodiment and the decoding method embodiment belong to a same concept. For details about a specific implementation process of the decoding apparatus, refer to the method embodiment. Details are not described herein again.

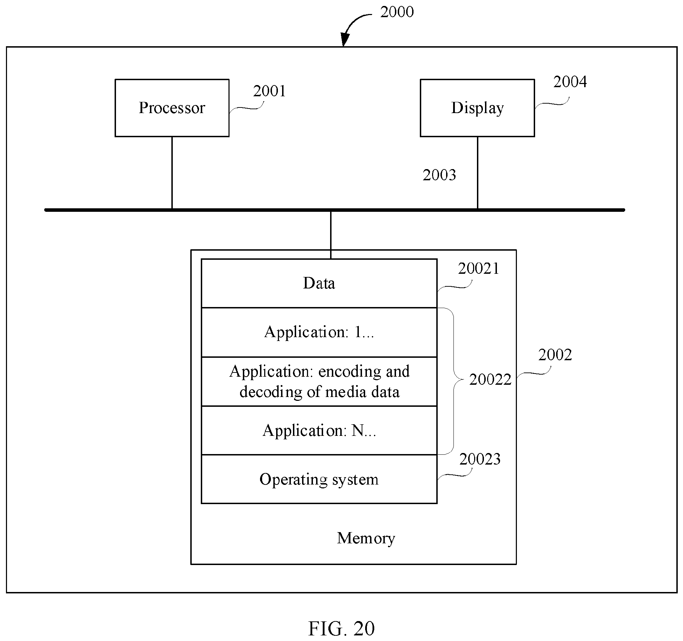

FIG. 20 is a schematic block diagram of an encoding and decoding apparatus 2000 according to an embodiment of this application. The encoding and decoding apparatus 2000 may include a processor 2001, a memory 2002, and a bus system 2003. The processor 2001 and the memory 2002 are connected through the bus system 2003. The memory 2002 is configured to store instructions. The processor 2001 is configured to execute the instructions stored in the memory 2002, to perform the encoding or decoding method described in embodiments of this application. To avoid repetition, details are not described herein again.

In this embodiment of this application, the processor 2001 may be a central processing unit (CPU), or the processor 2001 may be another general-purpose processor, a DSP, an ASIC, an FPGA or another programmable logic device, a discrete gate or transistor logic device, a discrete hardware component, or the like. The general-purpose processor may be a microprocessor, or the processor may be any conventional processor or the like.

The memory 2002 may include a ROM device or a RAM device. Any other appropriate type of storage device may also serve as the memory 2002. The memory 2002 may include code and data 20021 that are accessed by the processor 2001 through the bus system 2003. The memory 2002 may further include an operating system 20023 and an application program 20022. The application program 20022 includes at least one program that enables the processor 2001 to perform the encoding or decoding method described in embodiments of this application. For example, the application program 20022 may include applications 1 to N, and further include an encoding or decoding application (referred to as a coding application for short) for performing the encoding or decoding method described in embodiments of this application.

In addition to a data bus, the bus system 2003 may further include a power bus, a control bus, a status signal bus, and the like. However, for clarity of description, various buses are marked as the bus system 2003 in the figure.

Optionally, the encoding and decoding apparatus 2000 may further include one or more output devices, for example, a display 2004. In an example, the display 2004 may be a touch display that combines a display and a touch unit that operably senses a touch input. The display 2004 may be connected to the processor 2001 through the bus system 2003.

It should be noted that the encoding and decoding apparatus 2000 may perform the encoding method in embodiments of this application or the decoding method in embodiments of this application.

A person skilled in the art can understand that the functions described with reference to various illustrative logical blocks, modules, and algorithm steps disclosed and described in this specification may be implemented by hardware, software, firmware, or any combination thereof. If implemented by software, the functions described with reference to the illustrative logical blocks, modules, and steps may be stored in or transmitted through a computer-readable medium as one or more instructions or code and executed by a hardware-based processing unit. The computer-readable medium may include a computer-readable storage medium, which corresponds to a tangible medium such as a data storage medium, or may include any communication medium that facilitates transmission of a computer program from one place to another place (for example, according to a communication protocol). In this manner, the computer-readable medium may generally correspond to: (1) a non-transitory tangible computer-readable storage medium, or (2) a communication medium such as a signal or a carrier. The data storage medium may be any usable medium that can be accessed by one or more computers or one or more processors to retrieve instructions, code, and/or data structures for implementing technologies described in this application. A computer program product may include a computer-readable medium.

As an example rather than a limitation, the computer-readable storage medium may include a RAM, a ROM, an EEPROM, a CD-ROM or another compact disc storage apparatus, a magnetic disk storage apparatus or another magnetic storage apparatus, a flash memory, or any other medium that can be used to store desired program code in a form of instructions or data structures and that can be accessed by a computer. In addition, any connection is properly referred to as a computer-readable medium. For example, if instructions are transmitted from a website, a server, or another remote source through a coaxial cable, an optical fiber, a twisted pair, a digital subscriber line (DSL), or a wireless technology such as infrared, radio, or microwave, the coaxial cable, the optical fiber, the twisted pair, the DSL, or the wireless technology such as infrared, radio, or microwave is included in a definition of the medium. However, it should be understood that the computer-readable storage medium and the data storage medium do not include connections, carriers, signals, or other transitory media, but are actually non-transitory tangible storage media. Disks and discs used in this specification include a compact disc (CD), a laser disc, an optical disc, a DVD, and a Blu-ray disc. The disks usually reproduce data magnetically, and the discs reproduce data optically through lasers. Combinations of the foregoing items should also be included in the scope of the computer-readable medium.

Instructions may be executed by one or more processors such as one or more digital signal processors (DSP), general-purpose microprocessors, application-specific integrated circuits (ASIC), field programmable gate arrays (FPGA), or other equivalent integrated or discrete logic circuits. Therefore, the term "processor" used in this specification may refer to the foregoing structure or any other structure suitable for implementing technologies described in this specification. In addition, in some aspects, the functions described with reference to the illustrative logical blocks, modules, and steps described in this specification may be provided in dedicated hardware and/or software modules configured for encoding and decoding, or may be integrated into a combined codec. In addition, the technologies may be completely implemented in one or more circuits or logic elements. In an example, various illustrative logic blocks, units, and modules in the encoder 100 and the decoder 200 may be understood as corresponding circuit devices or logic elements.

Technologies in embodiments of this application may be implemented in various apparatuses or devices, including a wireless handset, an integrated circuit (IC), or a set of ICs (for example, a chip set). Various components, modules, or units are described in embodiments of this application to emphasize functional aspects of apparatuses configured to perform disclosed technologies, but do not necessarily need to be implemented by different hardware units. Actually, as described above, various units may be combined into a codec hardware unit in combination with appropriate software and/or firmware, or may be provided by interoperable hardware units (including the one or more processors described above).

To be specific, all or some of the foregoing embodiments may be implemented by software, hardware, firmware, or any combination thereof. When software is used to implement the embodiments, all or some of the embodiments may be implemented in a form of a computer program product. The computer program product includes one or more computer instructions. When the computer instructions are loaded and executed on a computer, all or some of processes or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible to the computer, or a data storage device, for example, a server or a data center, integrating one or more usable media. The usable medium may be a magnetic medium (for example, a floppy disk, a hard disk, or a magnetic tape), an optical medium (for example, a digital versatile disc (DVD)), a semiconductor medium (for example, a solid-state drive (SSD)), or the like. It should be noted that the computer-readable storage medium mentioned in embodiments of this application may be a non-volatile storage medium, namely, a non-transitory storage medium.

It should be understood that "a plurality of" mentioned in this specification indicates two or more. In descriptions of embodiments of this application, "/" indicates "or", unless otherwise specified. For example, A/B may indicate A or B. The term "and/or" in this specification describes only an association relationship between associated objects, and indicates that three relationships may exist. For example, A and/or B may indicate the following three cases: Only A exists, both A and B exist, and only B exists. In addition, to clearly describe technical solutions in embodiments of this application, terms such as "first" and "second" are used in embodiments of this application to distinguish between same items or similar items that provide basically same functions or purposes. A person skilled in the art can understand that the terms such as "first" and "second" do not limit a quantity or an execution sequence, and the terms such as "first" and "second" do not indicate a definite difference.

It should be noted that information (including but not limited to user equipment information, personal information of a user, and the like), data (including but not limited to data used for analysis, stored data, displayed data, and the like), and signals in embodiments of this application are used under authorization by the user or full authorization by all parties, and capturing, use, and processing of related data need to conform to related laws, regulations, and standards of related countries and regions. For example, the media data in embodiments of this application is obtained under full authorization.

## Claims

1. An encoding method, wherein the method comprises:
determining (601) a first whitened spectrum for to-be-encoded media data, the to-be-encoded media data is an audio signal;
shaping (602) the first whitened spectrum to obtain a second whitened spectrum, wherein a spectral amplitude of the second whitened spectrum in a target frequency band is greater than or equal to a spectral amplitude of the first whitened spectrum in the target frequency band, a dynamic range of statistical average energy distribution of the second whitened spectrum is smaller than a dynamic range of statistical average energy distribution of the first whitened spectrum;
processing (603) the second whitened spectrum by using an encoding neural network model to obtain a first latent variable, wherein the first latent variable indicates a feature of the second whitened spectrum; and
encoding (604) the first latent variable into a bitstream.

2. The method according to claim 1, wherein the target frequency band is preset, or the target frequency band is determined based on the first whitened spectrum.

3. The method according to claim 2, wherein if the target frequency band is determined based on the first whitened spectrum, before the shaping the first whitened spectrum to obtain a second whitened spectrum, the method further comprises:
dividing a spectral range of the media data into a first quantity of first frequency subbands, wherein the target frequency band covers an entire range or a partial range of the spectral range of the media data;
determining an average value of spectral energy of the first whitened spectrum in each of the first quantity of first frequency subbands to obtain a first quantity of average values of spectral energy of frequency subbands;
determining an average value of spectral energy of the first whitened spectrum within the spectral range; and
determining, based on the average value of spectral energy and the first quantity of average values of spectral energy of frequency subbands, a first frequency subband comprised in the target frequency band.

4. The method according to claim 3, wherein the determining, based on the average value of spectral energy and the first quantity of average values of spectral energy of frequency subbands, a first frequency subband comprised in the target frequency band comprises:
using a first frequency subband corresponding to an average value of spectral energy, in the first quantity of average values of spectral energy of frequency subbands, whose difference from the average value of spectral energy exceeds a specified threshold as the first frequency subband comprised in the target frequency band.

5. The method according to any one of claims 1 to 4, wherein the shaping the first whitened spectrum to obtain a second whitened spectrum comprises:
shaping the first whitened spectrum based on a gain adjustment factor to obtain the second whitened spectrum.

6. The method according to claim 5, wherein the target frequency band comprises a second quantity of second frequency subbands, and the gain adjustment factor comprises an adjustment factor corresponding to each of the second quantity of second frequency subbands; and
the shaping the first whitened spectrum based on a gain adjustment factor to obtain the second whitened spectrum comprises:
determining a spectral value of the first whitened spectrum at a frequency in each of the second quantity of second frequency subbands; and
adjusting the spectral value of the first whitened spectrum at the frequency in each of the second quantity of second frequency subbands based on an adjustment factor corresponding to each of the second quantity of second frequency subbands, to obtain the second whitened spectrum.

7. The method according to claim 6, wherein adjustment factors corresponding to all of the second quantity of second frequency subbands is determined in a same manner or different manners, and an adjustment factor corresponding to a first to-be-adjusted frequency subband of the second quantity of second frequency subbands meets the following condition:
frequencies in the first to-be-adjusted frequency subband correspond to one adjustment factor, and the adjustment factor is a preset value; or
frequencies in the first to-be-adjusted frequency subband correspond to different adjustment factors, and adjustment factors corresponding to at least a part of the frequencies are determined through linear interpolation; or
adjustment factors corresponding to frequencies in the first to-be-adjusted frequency subband are different, and the adjustment factors corresponding to the frequencies are determined according to a preset function.

8. The method according to claim 7, wherein the adjustment factors corresponding to the at least a part of the frequencies are determined in the following manner:
determining a start adjustment factor corresponding to the first to-be-adjusted frequency subband;
determining a stop adjustment factor corresponding to the first to-be-adjusted frequency subband; and
determining, based on the start adjustment factor and the stop adjustment factor through linear interpolation, the adjustment factors corresponding to the at least a part of the frequencies.

9. The method according to claim 8, wherein the at least a part of the frequencies do not comprise a start frequency or a stop frequency of the first to-be-adjusted frequency subband; and
an adjustment factor corresponding to the start frequency is the start adjustment factor, and an adjustment factor corresponding to the stop frequency is the stop adjustment factor.

10. A decoding method, wherein the method comprises:
determining (901) a reconstructed first latent variable based on a bitstream of an audio signal;
processing the reconstructed first latent variable by using a decoding neural network model to obtain a reconstructed second whitened spectrum, a dynamic range of statistical average energy distribution of the reconstructed second whitened spectrum is smaller than a dynamic range of statistical average energy distribution of the first reconstructed whitened spectrum;
adjusting (902) the reconstructed second whitened spectrum to obtain a reconstructed first whitened spectrum, wherein a spectral amplitude of the reconstructed first whitened spectrum in a target frequency band is less than or equal to a spectral amplitude of the reconstructed second whitened spectrum in the target frequency band; and
determining (903) reconstructed media data based on the reconstructed first whitened spectrum.

11. The method according to claim 10, wherein the adjusting the reconstructed second whitened spectrum to obtain a reconstructed first whitened spectrum comprises:
adjusting the reconstructed second whitened spectrum based on a gain adjustment factor to obtain the reconstructed first whitened spectrum.

12. The method according to claim 11, wherein the target frequency band comprises a second quantity of second frequency subbands, and the gain adjustment factor comprises an adjustment factor corresponding to each of the second quantity of second frequency subbands; and
the adjusting the reconstructed second whitened spectrum based on a gain adjustment factor to obtain the reconstructed first whitened spectrum comprises:
determining a spectral value of the reconstructed second whitened spectrum at a frequency in each of the second quantity of second frequency subbands; and
adjusting the spectral value of the reconstructed second whitened spectrum at the frequency in each of the second quantity of second frequency subbands based on an adjustment factor corresponding to each of the second quantity of second frequency subbands, to obtain the reconstructed first whitened spectrum.

13. An encoder-side device, wherein the encoder-side device comprises a memory and a processor; and
the memory is configured to store a computer program, and the processor is configured to execute the computer program stored in the memory, to implement the encoding method according to any one of claims 1 to 9.

14. A decoder-side device, wherein the decoder-side device comprises a memory and a processor; and
the memory is configured to store a computer program, and the processor is configured to execute the computer program stored in the memory, to implement the decoding method according to any one of claims 10 to 12.

15. A computer-readable storage medium, comprising the bitstream obtained in the encoding method according to any one of claims 1 to 9.

## Patentansprüche

1. Codierverfahren, wobei das Verfahren umfasst:
Bestimmen (601) eines ersten geweißten Spektrums für zu codierende Mediendaten, wobei die zu codierenden Mediendaten ein Audiosignal sind;
Formen (602) des ersten geweißten Spektrums, um ein zweites geweißtes Spektrum zu erhalten, wobei eine spektrale Amplitude des zweiten geweißten Spektrums in einem Zielfrequenzband größer als oder gleich einer spektralen Amplitude des ersten geweißten Spektrums in dem Zielfrequenzband ist, ein Dynamikbereich einer statistischen durchschnittlichen Energieverteilung des zweiten geweißten Spektrums kleiner als ein Dynamikbereich der statistischen durchschnittlichen Energieverteilung des ersten geweißten Spektrums ist;
Verarbeiten (603) des zweiten geweißten Spektrums durch Verwenden eines Codiermodells eines neuronalen Netzwerks, um eine erste latente Variable zu erhalten, wobei die erste latente Variable ein Merkmal des zweiten geweißten Spektrums anzeigt; und
Codieren (604) der ersten latenten Variablen in einen Bitstrom.

2. Verfahren nach Anspruch 1, wobei das Zielfrequenzband voreingestellt ist, oder das Zielfrequenzband basierend auf dem ersten geweißten Spektrum bestimmt wird.

3. Verfahren nach Anspruch 2, wobei, falls das Zielfrequenzband basierend auf dem ersten geweißten Spektrum bestimmt wird, vor dem Formen des ersten geweißten Spektrums, um ein zweites geweißtes Spektrum zu erhalten, das Verfahren ferner umfasst:
Unterteilen eines spektralen Bereichs der Mediendaten in eine erste Anzahl von ersten Frequenzteilbändern, wobei das Zielfrequenzband einen gesamten Bereich oder einen Teilbereich des spektralen Bereichs der Mediendaten abdeckt;
Bestimmen eines Durchschnittswerts der spektralen Energie des ersten geweißten Spektrums in jedem der ersten Anzahl von ersten Frequenzteilbändern, um eine erste Anzahl von Durchschnittswerten der spektralen Energie von Frequenzteilbändern zu erhalten;
Bestimmen eines Durchschnittswerts der spektralen Energie des ersten geweißten Spektrums innerhalb des spektralen Bereichs; und
Bestimmen, basierend auf dem Durchschnittswert der spektralen Energie und der ersten Anzahl von Durchschnittswerten der spektralen Energie von Frequenzteilbändern, eines ersten Frequenzteilbands, das in dem Zielfrequenzband umfasst ist.

4. Verfahren nach Anspruch 3, wobei das Bestimmen, basierend auf dem Durchschnittswert der spektralen Energie und der ersten Anzahl von Durchschnittswerten der spektralen Energie von Frequenzteilbändern, eines ersten Frequenzteilbands, das in dem Zielfrequenzband umfasst ist, umfasst:
Verwenden eines ersten Frequenzteilbands, das einem Durchschnittswert de spektralen Energie entspricht, in der ersten Anzahl von Durchschnittswerten der spektralen Energie von Frequenzteilbändern, deren Differenz von dem Durchschnittswert der spektralen Energie einen spezifizierten Schwellenwert überschreitet, als das erste Frequenzteilband, das in dem Zielfrequenzband umfasst ist.

5. Verfahren nach einem der Ansprüche 1 bis 4, wobei das Formen des ersten geweißten Spektrums, um ein zweites geweißtes Spektrum zu erhalten, umfasst:
Formen des ersten geweißten Spektrums basierend auf einem Verstärkungsanpassungsfaktor, um das zweite geweißte Spektrum zu erhalten.

6. Verfahren nach Anspruch 5, wobei das Zielfrequenzband eine zweite Anzahl von zweiten Frequenzteilbändern umfasst, und der Verstärkungsanpassungsfaktor einen Anpassungsfaktor, der jedem der zweiten Anzahl von zweiten Frequenzteilbändern entspricht, umfasst; und
das Formen des ersten geweißten Spektrums basierend auf einem Verstärkungsanpassungsfaktor, um das zweite geweißte Spektrum zu erhalten, umfasst:
Bestimmen eines spektralen Werts des ersten geweißten Spektrums bei einer Frequenz in jedem der zweiten Anzahl von zweiten Frequenzteilbändern; und
Anpassen des spektralen Werts des ersten geweißten Spektrums bei der Frequenz in jedem der zweiten Anzahl von zweiten Frequenzteilbändern basierend auf einem Anpassungsfaktor, der jedem der zweiten Anzahl von zweiten Frequenzteilbändern entspricht, um das zweite geweißte Spektrum zu erhalten.

7. Verfahren nach Anspruch 6, wobei Anpassungsfaktoren, die allen der zweiten Anzahl von zweiten Frequenzteilbändern entsprechen, auf eine selbe Weise oder unterschiedliche Weisen bestimmt werden, und ein Anpassungsfaktor, der einem ersten anzupassenden Frequenzteilband der zweiten Anzahl von zweiten Frequenzteilbändern entspricht, die folgende Bedingung erfüllt:
Frequenzen in dem ersten anzupassenden Frequenzteilband entsprechen einem Anpassungsfaktor, und der Anpassungsfaktor ist ein voreingestellter Wert; oder
Frequenzen in dem ersten anzupassenden Frequenzteilband entsprechen unterschiedlichen Anpassungsfaktoren, und Anpassungsfaktoren, die mindestens einem Teil der Frequenzen entsprechen, werden mittels linearer Interpolation bestimmt; oder
Anpassungsfaktoren, die Frequenzen in dem ersten anzupassenden Frequenzteilband entsprechen, sind unterschiedlich, und die Anpassungsfaktoren, die den Frequenzen entsprechen, werden gemäß einer voreingestellten Funktion bestimmt.

8. Verfahren nach Anspruch 7, wobei die Anpassungsfaktoren, die dem mindestens einen Teil der Frequenzen entsprechen, auf die folgende Weise bestimmt werden:
Bestimmen eines Startanpassungsfaktors, der dem ersten anzupassenden Frequenzteilband entspricht;
Bestimmen eines Stoppanpassungsfaktors, der dem ersten anzupassenden Frequenzteilband entspricht; und
Bestimmen, basierend auf dem Startanpassungsfaktor und dem Stoppanpassungsfaktor mittels linearer Interpolation, der Anpassungsfaktoren, die dem mindestens einen Teil der Frequenzen entsprechen.

9. Verfahren nach Anspruch 8, wobei der mindestens eine Teil der Frequenzen keine Startfrequenz oder keine Stoppfrequenz des ersten anzupassenden Frequenzteilbands umfasst; und
ein Anpassungsfaktor, der der Startfrequenz entspricht, der Startanpassungsfaktor ist, und ein Anpassungsfaktor, der der Stoppfrequenz entspricht, der Stoppanpassungsfaktor ist.

10. Decodierverfahren, wobei das Verfahren umfasst:
Bestimmen (901) einer rekonstruierten ersten latenten Variablen basierend auf einem Bitstrom eines Audiosignals;
Verarbeiten der rekonstruierten ersten latenten Variablen durch Verwenden eines Decodiermodells des neuronalen Netzwerks, um ein rekonstruiertes zweites geweißtes Spektrum zu erhalten, wobei ein Dynamikbereich der statistischen durchschnittlichen Energieverteilung des rekonstruierten zweiten geweißten Spektrums kleiner als ein Dynamikbereich der statistischen durchschnittlichen Energieverteilung des ersten rekonstruierten geweißten Spektrums ist;
Anpassen (902) des rekonstruierten zweiten geweißten Spektrums, um ein rekonstruiertes erstes geweißtes Spektrum zu erhalten, wobei eine spektrale Amplitude des rekonstruierten ersten geweißten Spektrums in einem Zielfrequenzband kleiner als oder gleich einer spektralen Amplitude des rekonstruierten zweiten geweißten Spektrums in dem Zielfrequenzband ist; und
Bestimmen (903) rekonstruierter Mediendaten basierend auf dem rekonstruierten ersten geweißten Spektrum.

11. Verfahren nach Anspruch 10, wobei das Anpassen des rekonstruierten zweiten geweißten Spektrums, um ein rekonstruiertes erstes geweißtes Spektrum zu erhalten, umfasst:
Anpassen des rekonstruierten zweiten geweißten Spektrums basierend auf einem Verstärkungsanpassungsfaktor, um das rekonstruierte erste geweißte Spektrum zu erhalten.

12. Verfahren nach Anspruch 11, wobei das Zielfrequenzband eine zweite Anzahl von zweiten Frequenzteilbändern umfasst, und der Verstärkungsanpassungsfaktor einen Anpassungsfaktor, der jedem der zweiten Anzahl von zweiten Frequenzteilbändern entspricht, umfasst; und
das Anpassen des rekonstruierten zweiten geweißten Spektrums basierend auf einem Verstärkungsanpassungsfaktor, um das rekonstruierte erste geweißte Spektrum zu erhalten, umfasst:
Bestimmen eines spektralen Werts des rekonstruierten zweiten geweißten Spektrums bei einer Frequenz in jedem der zweiten Anzahl von zweiten Frequenzteilbändern; und
Anpassen des spektralen Werts des rekonstruierten zweiten geweißten Spektrums bei der Frequenz in jedem der zweiten Anzahl von zweiten Frequenzteilbändern basierend auf einem Anpassungsfaktor, der jedem der zweiten Anzahl von zweiten Frequenzteilbändern entspricht, um das rekonstruierte erste geweißte Spektrum zu erhalten.

13. Codiererseitige Vorrichtung, wobei die codiererseitige Vorrichtung einen Speicher und einen Prozessor umfasst: und
der Speicher konfiguriert ist, um ein Computerprogramm zu speichern, und der Prozessor konfiguriert ist, um das Computerprogramm, das in dem Speicher gespeichert ist, auszuführen, um das Codierverfahren nach einem der Ansprüche 1 bis 9 zu implementieren.

14. Decodiererseitige Vorrichtung, wobei die decodiererseitige Vorrichtung einen Speicher und einen Prozessor umfasst; und
der Speicher konfiguriert ist, um ein Computerprogramm zu speichern, und der Prozessor konfiguriert ist, um das Computerprogramm, das in dem Speicher gespeichert ist, auszuführen, um das Decodierverfahren nach einem der Ansprüche 10 bis 12 zu implementieren.

15. Computerlesbares Speicherungsmedium, das den Bitstrom, der in dem Codierverfahren nach einem der Ansprüche 1 bis 9 erhalten wird, umfasst.

## Revendications

1. Procédé de codage, dans lequel le procédé comprend :
la détermination (601) d'un premier spectre blanchi pour des données multimédias à coder, les données multimédias à coder étant un signal audio ;
la mise en forme (602) du premier spectre blanchi pour obtenir un second spectre blanchi, dans lequel une amplitude spectrale du second spectre blanchi dans une bande de fréquences cible est supérieure ou égale à une amplitude spectrale du premier spectre blanchi dans la bande de fréquences cible, une plage dynamique de répartition d'énergie moyenne statistique du second spectre blanchi est inférieure à une plage dynamique de répartition d'énergie moyenne statistique du premier spectre blanchi ;
le traitement (603) du second spectre blanchi en utilisant un modèle de réseau neuronal de codage pour obtenir une première variable latente, dans lequel la première variable latente indique une caractéristique du second spectre blanchi ; et
le codage (604) de la première variable latente dans un flux binaire.

2. Procédé selon la revendication 1, dans lequel la bande de fréquences cible est prédéfinie, ou la bande de fréquences cible est déterminée sur la base du premier spectre blanchi.

3. Procédé selon la revendication 2, dans lequel, si la bande de fréquences cible est déterminée sur la base du premier spectre blanchi, avant la mise en forme du premier spectre blanchi pour obtenir un second spectre blanchi, le procédé comprend en outre :
la division d'une gamme spectrale des données multimédias en une première quantité de premières sous-bandes de fréquences, dans lequel la bande de fréquences cible couvre une gamme entière ou une gamme partielle de la gamme spectrale des données multimédias ;
la détermination d'une valeur moyenne d'énergie spectrale du premier spectre blanchi dans chacune de la première quantité de premières sous-bandes de fréquences pour obtenir une première quantité de valeurs moyennes d'énergie spectrale de sous-bandes de fréquences ;
la détermination d'une valeur moyenne d'énergie spectrale du premier spectre blanchi au sein de la gamme spectrale ; et
la détermination, sur la base de la valeur moyenne d'énergie spectrale et de la première quantité de valeurs moyennes d'énergie spectrale de sous-bandes de fréquences, d'une première sous-bande de fréquences comprise dans la bande de fréquences cible.

4. Procédé selon la revendication 3, dans lequel la détermination, sur la base de la valeur moyenne d'énergie spectrale et de la première quantité de valeurs moyennes d'énergie spectrale de sous-bandes de fréquences, d'une première sous-bande de fréquences comprise dans la bande de fréquences cible comprend :
l'utilisation d'une première sous-bande de fréquences correspondant à une valeur moyenne d'énergie spectrale, dans la première quantité de valeurs moyennes d'énergie spectrale de sous-bandes de fréquences, dont la différence par rapport à la valeur moyenne d'énergie spectrale dépasse un seuil spécifié, en tant que première sous-bande de fréquences comprise dans la bande de fréquences cible.

5. Procédé selon l'une quelconque des revendications 1 à 4, dans lequel la mise en forme du premier spectre blanchi pour obtenir un second spectre blanchi comprend :
la mise en forme du premier spectre blanchi sur la base d'un facteur d'ajustement de gain pour obtenir le second spectre blanchi.

6. Procédé selon la revendication 5, dans lequel la bande de fréquences cible comprend une seconde quantité de secondes sous-bandes de fréquences, et le facteur d'ajustement de gain comprend un facteur d'ajustement correspondant à chacune de la seconde quantité de secondes sous-bandes de fréquences ; et
la mise en forme du premier spectre blanchi sur la base d'un facteur d'ajustement de gain pour obtenir le second spectre blanchi comprend :
la détermination d'une valeur spectrale du premier spectre blanchi à une fréquence dans chacune de la seconde quantité de secondes sous-bandes de fréquences ; et
l'ajustement de la valeur spectrale du premier spectre blanchi à la fréquence dans chacune de la seconde quantité de secondes sous-bandes de fréquences sur la base d'un facteur d'ajustement correspondant à chacune de la seconde quantité de secondes sous-bandes de fréquences, pour obtenir le second spectre blanchi.

7. Procédé selon la revendication 6, dans lequel des facteurs d'ajustement correspondant à la totalité de la seconde quantité de secondes sous-bandes de fréquences sont déterminés de la même manière ou de manières différentes, et un facteur d'ajustement correspondant à une première sous-bande de fréquences à ajuster de la seconde quantité de secondes sous-bandes de fréquences satisfait à la condition suivante :
des fréquences dans la première sous-bande de fréquences à ajuster correspondent à un facteur d'ajustement, et le facteur d'ajustement est une valeur prédéfinie ; ou
des fréquences dans la première sous-bande de fréquences à ajuster correspondent à différents facteurs d'ajustement, et des facteurs d'ajustement correspondant à au moins une partie des fréquences sont déterminés par le biais d'une interpolation linéaire ; ou
des facteurs d'ajustement correspondant à des fréquences dans la première sous-bande de fréquences à ajuster sont différents, et les facteurs d'ajustement correspondant aux fréquences sont déterminés selon une fonction prédéfinie.

8. Procédé selon la revendication 7, dans lequel les facteurs d'ajustement correspondant à l'au moins une partie des fréquences sont déterminés de la manière suivante :
déterminer un facteur d'ajustement de départ correspondant à la première sous-bande de fréquences à ajuster ;
déterminer un facteur d'ajustement d'arrêt correspondant à la première sous-bande de fréquences à ajuster ; et
déterminer, sur la base du facteur d'ajustement de départ et du facteur d'ajustement d'arrêt par le biais d'une interpolation linéaire, les facteurs d'ajustement correspondant à l'au moins une partie des fréquences.

9. Procédé selon la revendication 8, dans lequel l'au moins une partie des fréquences ne comprend pas de fréquence de départ ni de fréquence d'arrêt de la première sous-bande de fréquences à ajuster ; et
un facteur d'ajustement correspondant à la fréquence de départ est le facteur d'ajustement de départ, et un facteur d'ajustement correspondant à la fréquence d'arrêt est le facteur d'ajustement d'arrêt.

10. Procédé de décodage, dans lequel le procédé comprend :
la détermination (901) d'une première variable latente reconstruite sur la base d'un flux binaire d'un signal audio ;
le traitement de la première variable latente reconstruite en utilisant un modèle de réseau neuronal de décodage pour obtenir un second spectre blanchi reconstruit, une plage dynamique de répartition d'énergie moyenne statistique du second spectre blanchi reconstruit est inférieure à une plage dynamique de répartition d'énergie moyenne statistique du premier spectre blanchi reconstruit ;
l'ajustement (902) du second spectre blanchi reconstruit pour obtenir un premier spectre blanchi reconstruit, dans lequel une amplitude spectrale du premier spectre blanchi reconstruit dans une bande de fréquences cible est inférieure ou égale à une amplitude spectrale du second spectre blanchi reconstruit dans la bande de fréquences cible ; et
la détermination (903) de données multimédia reconstruites sur la base du premier spectre blanchi reconstruit.

11. Procédé selon la revendication 10, dans lequel l'ajustement du second spectre blanchi reconstruit pour obtenir un premier spectre blanchi reconstruit comprend :
l'ajustement du second spectre blanchi reconstruit sur la base d'un facteur d'ajustement de gain pour obtenir le premier spectre blanchi reconstruit.

12. Procédé selon la revendication 11, dans lequel la bande de fréquences cible comprend une seconde quantité de secondes sous-bandes de fréquences, et le facteur d'ajustement de gain comprend un facteur d'ajustement correspondant à chacune de la seconde quantité de secondes sous-bandes de fréquences ; et l'ajustement du second spectre blanchi reconstruit sur la base d'un facteur d'ajustement de gain pour obtenir le premier spectre blanchi reconstruit comprend :
la détermination d'une valeur spectrale du second spectre blanchi reconstruit à une fréquence dans chacune de la seconde quantité de secondes sous-bandes de fréquences ; et
l'ajustement de la valeur spectrale du second spectre blanchi reconstruit à la fréquence dans chacune de la seconde quantité de secondes sous-bandes de fréquences sur la base d'un facteur d'ajustement correspondant à chacune de la seconde quantité de secondes sous-bandes de fréquences, pour obtenir le premier spectre blanchi reconstruit.

13. Dispositif côté codeur, dans lequel le dispositif côté codeur comprend une mémoire et un processeur ; et
la mémoire est configurée pour stocker un programme informatique, et le processeur est configuré pour exécuter le programme informatique stocké dans la mémoire, pour mettre en œuvre le procédé de codage selon l'une quelconque des revendications 1 à 9.

14. Dispositif côté décodeur, dans lequel le dispositif côté décodeur comprend une mémoire et un processeur ; et
la mémoire est configurée pour stocker un programme informatique, et le processeur est configuré pour exécuter le programme informatique stocké dans la mémoire, pour mettre en œuvre le procédé de décodage selon l'une quelconque des revendications 10 à 12.

15. Support de stockage lisible par un ordinateur, comprenant le flux binaire obtenu dans le procédé de codage selon l'une quelconque des revendications 1 à 9.
